# EUROPEAN PATENT APPLICATION

(11) **EP 4 779 640 A1**
(43) Date of publication of application: **22.07.2026**
(21) Application number: 24865304.0
(22) Date of filing: 02.09.2024
(51) Int. Cl.: G11C 11/56, G11C 17/16, H10B 20/25

(54) **SEMICONDUCTOR MEMORY DEVICE**

(30) Priority: 13.09.2023 JP 2023148560; 25.07.2024 WO PCT/JP2024/026625
(71) Applicant: Sony Semiconductor Solutions Corporation, Atsugi-shi, Kanagawa 243-0014 (JP)
(72) Inventor: TATSUNO, Taro, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/031497
(87) International publication number: WO 2025/057802

(57) **Abstract**

A semiconductor storage device according to one embodiment of the present disclosure includes: a first via provided in a path coupling a first coupling terminal and a coupling node to each other, the first via being configured to irreversibly come into a high resistance state by passage of current therethrough; a second via provided in a path coupling the coupling node and a second coupling terminal to each other, the second via being configured to irreversibly come into a high resistance state by passage of current therethrough; a third via provided in a path coupling the coupling node and a third coupling terminal to each other, the third via being configured to irreversibly come into a high resistance state by passage of current therethrough; and a write circuit coupled to the first coupling terminal, the second coupling terminal, and the third coupling terminal, the write circuit being configured to allow a write current to flow bidirectionally between the first coupling terminal and the second coupling terminal, and configured to allow the write current to flow bidirectionally between the first coupling terminal and the third coupling terminal.

## Description

### Technical Field

The present disclosure relates to a semiconductor storage device configured to store data.

### Background Art

Semiconductor storage devices include a storage device of OTP (One Time Programmable) type that enables writing of data only once. In such an OTP-type storage device, for example, data is stored by passing current through a storage element and thereby changing a resistance value of the storage element. For example, Patent Literature 1 discloses a semiconductor storage device in which an electrical fuse including a via is used.

### Citation List

### Patent Literature

Patent Literature 1: Japanese Unexamined Patent Application Publication No. 2009-252870

### Summary of the Invention

In such an OTP-type storage device, power consumption can become high when data is written. It is thus desired that power consumption be reducible while shortening writing time.

It is desirable to provide a semiconductor storage device that makes it possible to reduce power consumption while shortening writing time.

A semiconductor storage device according to one embodiment of the present disclosure includes a first via, a second via, a third via, and a write circuit. The first via is provided in a path coupling a first coupling terminal and a coupling node to each other, and is configured to irreversibly come into a high resistance state by passage of current therethrough. The second via is provided in a path coupling the coupling node and a second coupling terminal to each other, and is configured to irreversibly come into a high resistance state by passage of current therethrough. The third via is provided in a path coupling the coupling node and a third coupling terminal to each other, and is configured to irreversibly come into a high resistance state by passage of current therethrough. The write circuit is coupled to the first coupling terminal, the second coupling terminal, and the third coupling terminal, and is configured to allow a write current to flow bidirectionally between the first coupling terminal and the second coupling terminal, and configured to allow the write current to flow bidirectionally between the first coupling terminal and the third coupling terminal.

In the semiconductor storage device according to the embodiment of the present disclosure, the first via is provided in the path coupling the first coupling terminal and the coupling node to each other, the second via is provided in the path coupling the coupling node and the second coupling terminal to each other, and the third via is provided in the path coupling the coupling node and the third coupling terminal to each other. For example, the write current is allowed to flow bidirectionally between the first coupling terminal and the second coupling terminal by the write circuit. Further, for example, the write current is allowed to flow bidirectionally between the first coupling terminal and the third coupling terminal by the write circuit.

### Brief Description of Drawings

[FIG. 1] FIG. 1 is a block diagram illustrating a configuration example of a semiconductor storage device according to one embodiment of the present disclosure.
[FIG. 2] FIG. 2 is an explanatory diagram illustrating a configuration example of a storage circuit illustrated in FIG. 1.
[FIG. 3 ] FIG. 3 is another explanatory diagram illustrating a configuration example of the storage circuit illustrated in FIG. 1.
[FIG. 4A] FIG. 4A is an explanatory diagram illustrating an example of a write operation of the storage circuit illustrated in FIG. 1.
[FIG. 4B] FIG. 4B is an explanatory diagram illustrating another example of the write operation of the storage circuit illustrated in FIG. 1.
[FIG. 4C] FIG. 4C is an explanatory diagram illustrating another example of the write operation of the storage circuit illustrated in FIG. 1.
[FIG. 5] FIG. 5 is an explanatory diagram illustrating a relationship between the storage circuit illustrated in FIG. 1 and two bits to be stored.
[FIG. 6] FIG. 6 is a circuit diagram illustrating a configuration example of a write circuit illustrated in FIG. 1.
[FIG. 7] FIG. 7 is a circuit diagram illustrating a configuration example of a read circuit illustrated in FIG. 1.
[FIG. 8] FIG. 8 is a table presenting an example of the write operation of the semiconductor storage device illustrated in FIG. 1.
[FIG. 9A] FIG. 9A is an explanatory diagram illustrating an example of the write operation of the semiconductor storage device illustrated in FIG. 1.
[FIG. 9B] FIG. 9B is an explanatory diagram illustrating another example of the write operation of the semiconductor storage device illustrated in FIG. 1.
[FIG. 9C] FIG. 9C is an explanatory diagram illustrating another example of the write operation of the semiconductor storage device illustrated in FIG. 1.
[FIG. 10A] FIG. 10A is an explanatory diagram illustrating an example of a read operation of the semiconductor storage device illustrated in FIG. 1.
[FIG. 10B] FIG. 10B is an explanatory diagram illustrating another example of the read operation of the semiconductor storage device illustrated in FIG. 1.
[FIG. 11A] FIG. 11A is an explanatory diagram illustrating an example of the write operation of a storage circuit according to a modification example.
[FIG. 11B] FIG. 11B is an explanatory diagram illustrating an example of the write operation of a storage circuit according to another modification example.
[FIG. 11C] FIG. 11C is an explanatory diagram illustrating an example of the write operation of a storage circuit according to another modification example.
[FIG. 12A] FIG. 12A is an explanatory diagram illustrating an example of the write operation of a storage circuit according to another modification example.
[FIG. 12B] FIG. 12B is an explanatory diagram illustrating another example of the write operation of a storage circuit according to another modification example.
[FIG. 12C] FIG. 12C is an explanatory diagram illustrating another example of the write operation of a storage circuit according to another modification example.
[FIG. 13] FIG. 13 is a circuit diagram illustrating a configuration example of a write circuit according to another modification example.
[FIG. 14] FIG. 14 is a table presenting an example of the write operation of a semiconductor storage device according to another modification example.
[FIG. 15A] FIG. 15A is an explanatory diagram illustrating an example of the write operation of a semiconductor storage device according to another modification example.
[FIG. 15B] FIG. 15B is an explanatory diagram illustrating another example of the write operation of a semiconductor storage device according to another modification example.
[FIG. 15C] FIG. 15C is an explanatory diagram illustrating another example of the write operation of a semiconductor storage device according to another modification example.
[FIG. 16] FIG. 16 is an explanatory diagram illustrating a configuration example of a storage circuit according to another modification example.
[FIG. 17] FIG. 17 is another explanatory diagram illustrating a configuration example of a storage circuit according to another modification example.
[FIG. 18] FIG. 18 is an explanatory diagram illustrating a configuration example of a storage circuit according to another modification example.
[FIG. 19] FIG. 19 is an explanatory diagram illustrating a configuration example of a storage circuit according to another modification example.
[FIG. 20] FIG. 20 is an explanatory diagram illustrating a configuration example of a coupling part according to another modification example.
[FIG. 21] FIG. 21 is an explanatory diagram illustrating a configuration example of the coupling part illustrated in FIG. 20.
[FIG. 22] FIG. 22 is an explanatory diagram illustrating a configuration example of a coupling part according to another modification example.
[FIG. 23] FIG. 23 is an explanatory diagram illustrating a configuration example of a coupling part according to another modification example.
[FIG. 24] FIG. 24 is an explanatory diagram illustrating a configuration example of the coupling part illustrated in FIG. 23.
[FIG. 25] FIG. 25 is an explanatory diagram illustrating a configuration example of a coupling part according to another modification example.
[FIG. 26] FIG. 26 is an explanatory diagram illustrating a configuration example of the coupling part illustrated in FIG. 25.

### Modes for Carrying Out the Invention

In the following, an embodiment of the present disclosure is described in detail with reference to the drawings.

### <Embodiment>

### [Configuration Example]

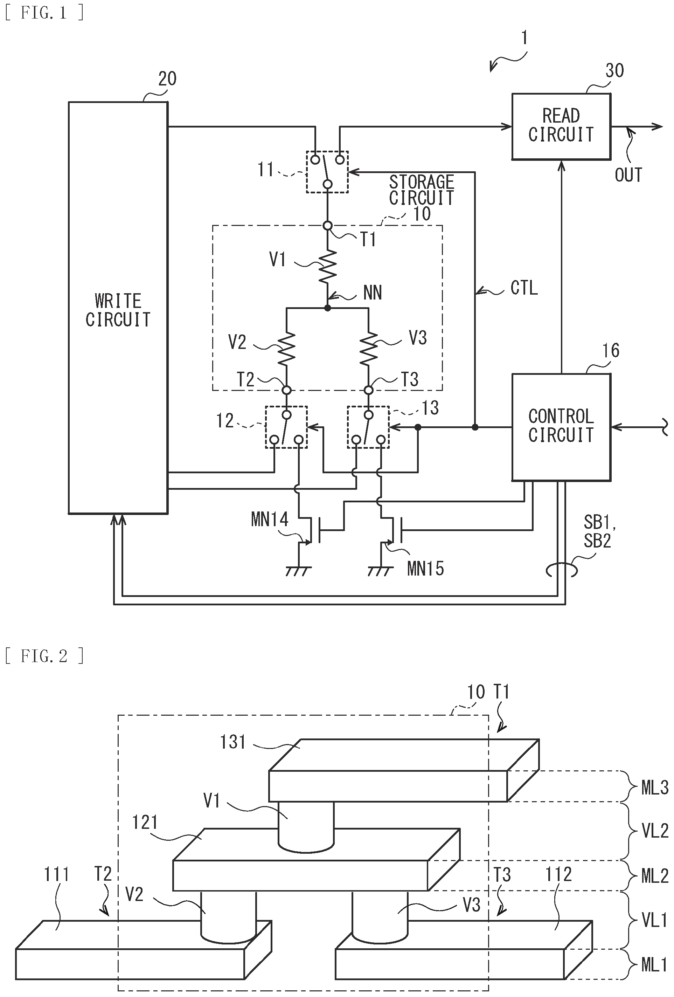

FIG. 1 illustrates a configuration example of a semiconductor storage device (a semiconductor storage device 1) according to an embodiment. The semiconductor storage device 1 is an OTP-type storage device. The semiconductor storage device 1 includes a storage circuit 10, switches 11 to 13, transistors MN14 and MN15, a write circuit 20, a read circuit 30, and a control circuit 16.

The storage circuit 10 is configured to store two bits of data. The storage circuit 10 includes vias V1 to V3. In FIG. 1, a symbol of a resistor is used to represent each of the vias V1 to V3. The via V1 has one end coupled to a terminal T1 and another end coupled to a node NN. The via V2 has one end coupled to the node NN and another end coupled to a terminal T2. The via V3 has one end coupled to the node NN and another end coupled to a terminal T3. As will be described later, the vias V1 to V3 are each configured to be broken and irreversibly change in resistance state into a high resistance state by passage of a write current Iw therethrough. Specifically, the vias V1 to V3 each change in resistance state into the high resistance state by occurrence of electromigration. This allows the storage circuit 10 to store data.

FIG. 2 illustrates a configuration example of the storage circuit 10. The storage circuit 10 includes wirings 111, 112, 121, and 131. In the semiconductor storage device 1, a metal wiring layer ML1, a via layer VL1, a metal wiring layer ML2, a via layer VL2, and a metal wiring layer ML3 are stacked in this order. The metal wiring layer ML1 is a lowermost metal wiring layer, the metal wiring layer ML2 is a second one from the lowermost metal wiring layer, and the metal wiring layer ML3 is a third one from the lowermost metal wiring layer.

The wiring 131 corresponds to the terminal T1, and is provided in the metal wiring layer ML3. The via V1 is provided in the via layer VL2. The wiring 121 corresponds to the node NN, and is provided in the metal wiring layer ML2. The vias V2 and V3 are provided in the via layer VL1. The wirings 111 and 112 correspond to the terminals T2 and T3, respectively, and are provided in the metal wiring layer ML1.

The via V1 has the one end coupled to the wiring 131, and the other end coupled to the wiring 121. The via V2 has the one end coupled to the wiring 121, and the other end coupled to the wiring 111. The via V3 has the one end coupled to the wiring 121, and the other end coupled to the wiring 112.

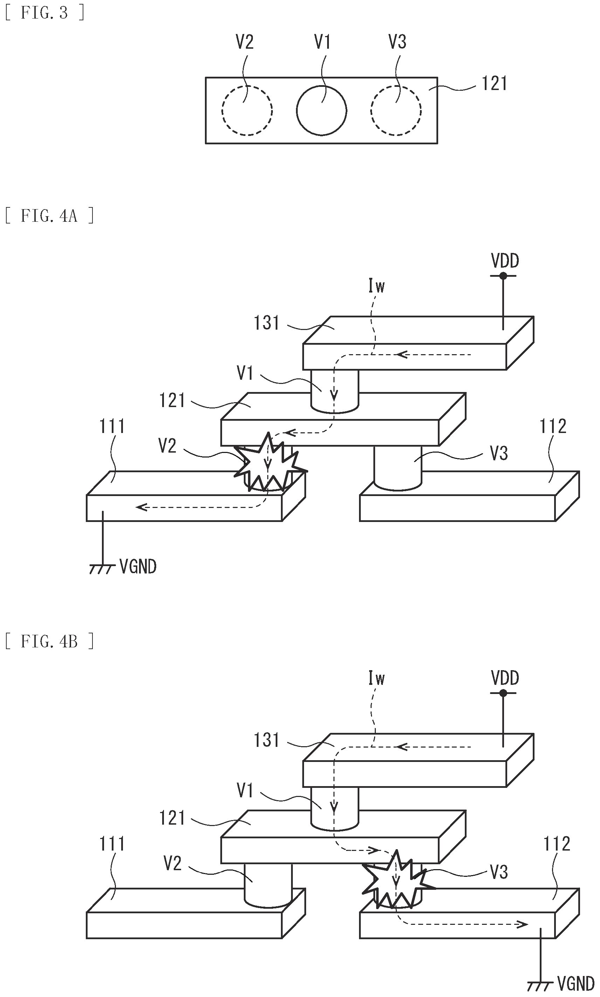

FIG. 3 illustrates a layout example of the vias V1 to V3. In FIG. 3, positions of the vias V1 to V3 as viewed from above in a stacking direction are illustrated. The via V2 is disposed near one end of the wiring 121 in a direction of extension thereof. The via V3 is disposed near another end of the wiring 121 in the direction of extension thereof. The via V1 is provided at a position between a position of the via V2 and a position of the via V3. In this example, the vias V2 and V3 are provided at mutually symmetrical positions as viewed from the via V1.

In the storage circuit 10, a write operation causes any one of the vias V1 to V3 to be selectively broken, and causes the resistance state of that via to change from a state where a resistance value is low (a low resistance state) to a state where a resistance value is high (the high resistance state). Data is thereby stored in the storage circuit 10.

FIGs. 4A to 4C illustrate an example of data write operation in the storage circuit 10. Before being broken, the vias V1 to V3 are each in the state where the resistance value is low (the low resistance state).

For example, as illustrated in FIG. 4A, in a case where a power supply voltage VDD is applied to the wiring 131, where a ground voltage VGND is applied to the wiring 111, and where the wiring 112 is in a floating state, the write current Iw flows through the wiring 131, the via V1, the wiring 121, the via V2, and the wiring 111 in this order. In such a case, in this example, the via V2 is broken and the resistance state of the via V2 is set to the high resistance state.

Further, for example, as illustrated in FIG. 4B, in a case where the power supply voltage VDD is applied to the wiring 131, where the wiring 111 is in the floating state, and where the ground voltage VGND is applied to the wiring 112, the write current Iw flows through the wiring 131, the via V1, the wiring 121, the via V3, and the wiring 112 in this order. In such a case, in this example, the via V3 is broken and the resistance state of the via V3 is set to the high resistance state.

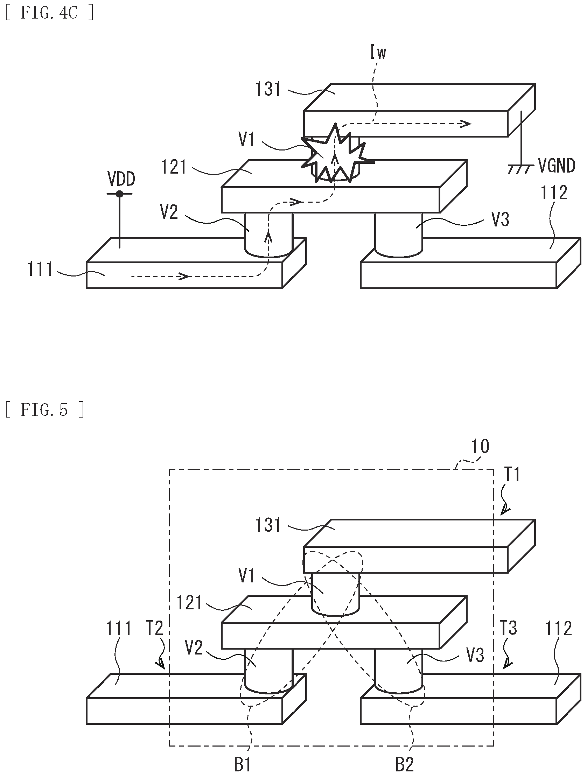

Further, for example, as illustrated in FIG. 4C, in a case where the ground voltage VGND is applied to the wiring 131, where the power supply voltage VDD is applied to the wiring 111, and where the wiring 112 is in the floating state, the write current Iw flows through the wiring 111, the via V2, the wiring 121, the via V1, and the wiring 131 in this order. In such a case, in this example, the via V1 is broken and the resistance state of the via V1 is set to the high resistance state.

In this example, as illustrated in FIGs. 4A and 4B, in a case where the write current Iw flows from the wiring 131 in the metal wiring layer ML3 toward the wiring 111 or the wiring 112 in the metal wiring layer ML1, the via V1 in the via layer VL2 is not broken but the via V2 or the via V3 in the via layer VL1 is broken. Further, as illustrated in FIG. 4C, in a case where the write current Iw flows from the wiring 111 or the wiring 112 in the metal wiring layer ML1 toward the wiring 131 in the metal wiring layer ML3, neither of the vias V2 and V3 in the via layer VL1 is broken but the via V1 in the via layer VL2 is broken. Such an operation is one example, and settings are possible based on, for example, a distance between the storage circuit 10 and the write circuit 20, a heat distribution in the storage circuit 10, structures of the vias V1 to V3, and the like. Such a storage circuit 10 has been prototyped and reproducibility of the operation has been confirmed.

FIG. 5 illustrates a relationship between the storage circuit 10 and two bits of data storable in the storage circuit 10. The storage circuit 10 is able to store two bits of data including bits B1 and B2. The bit B1 corresponds to a resistance value in a path coupling the terminal T1 (the wiring 131) and the terminal T2 (the wiring 111) to each other, and the bit B2 corresponds to a resistance value in a path coupling the terminal T1 (the wiring 131) and the terminal T3 (the wiring 112) to each other.

For example, as illustrated in FIG. 4A, in a case where the via V2 is in the high resistance state and the vias V1 and V3 are each in the low resistance state, the resistance value in the path coupling the terminal T1 and the terminal T2 to each other is high and the resistance value in the path coupling the terminal T1 and the terminal T3 to each other is low. Accordingly, in this example, the bit B1 is "1" and the bit B2 is "0".

Further, for example, as illustrated in FIG. 4B, in a case where the via V3 is in the high resistance state and the vias V1 and V2 are each in the low resistance state, the resistance value in the path coupling the terminal T1 and the terminal T2 to each other is low and the resistance value in the path coupling the terminal T1 and the terminal T3 to each other is high. Accordingly, in this example, the bit B1 is "0" and the bit B2 is "1".

Further, for example, as illustrated in FIG. 4C, in a case where the via V1 is in the high resistance state and the vias V2 and V3 are each in the low resistance state, the resistance value in the path coupling the terminal T1 and the terminal T2 to each other and the resistance value in the path coupling the terminal T1 and the terminal T3 to each other are both high. Accordingly, in this example, the bit B1 is "1" and the bit B2 is "1".

Further, for example, in a case where all the vias V1 to V3 are in the low resistance state, the resistance value in the path coupling the terminal T1 and the terminal T2 to each other and the resistance value in the path coupling the terminal T1 and the terminal T3 to each other are both low. Accordingly, in this example, the bit B1 is "0" and the bit B2 is "0".

In this way, it is possible for the storage circuit 10 to store the two bits of data in accordance with the resistance states of the three vias V1 to V3.

The switch 11 (FIG. 1) is configured to couple the terminal T1 of the storage circuit 10 to the write circuit 20 or the read circuit 30, based on a control signal CTL. The switch 12 is configured to couple the terminal T2 of the storage circuit 10 to the write circuit 20 or a drain of the transistor MN14, based on the control signal CTL. The switch 13 is configured to couple the terminal T3 of the storage circuit 10 to the write circuit 20 or a drain of the transistor MN15, based on the control signal CTL. The switches 11 to 13 include MOS (Metal Oxide Semiconductor) transistors. In a case where the semiconductor storage device 1 writes data into the storage circuit 10, the switches 11 to 13 couple the terminals T1 to T3 of the storage circuit 10 to the write circuit 20, based on the control signal CTL. Further, in a case where the semiconductor storage device 1 reads data from the storage circuit 10, the switches 11 to 13 couple the terminal T1 of the storage circuit 10 to the read circuit 30, couple the terminal T2 of the storage circuit 10 to the drain of the transistor MN14, and couple the terminal T3 of the storage circuit 10 to the drain of the transistor MN15, based on the control signal CTL.

The transistors MN14 and MN15 are N-type MOS (Metal Oxide Semiconductor) transistors. The transistor MN14 has a gate to which a control signal supplied from the control circuit 16 is to be applied, the drain coupled to the switch 12, and a source grounded. The transistor MN15 has a gate to which a control signal supplied from the control circuit 16 is to be applied, the drain coupled to the switch 13, and a source grounded.

The write circuit 20 is configured to write data into the storage circuit 10, based on signals SB1 and SB2 supplied from the control circuit 16. The signal SB1 corresponds to the bit B1, and the signal SB2 corresponds to the bit B2.

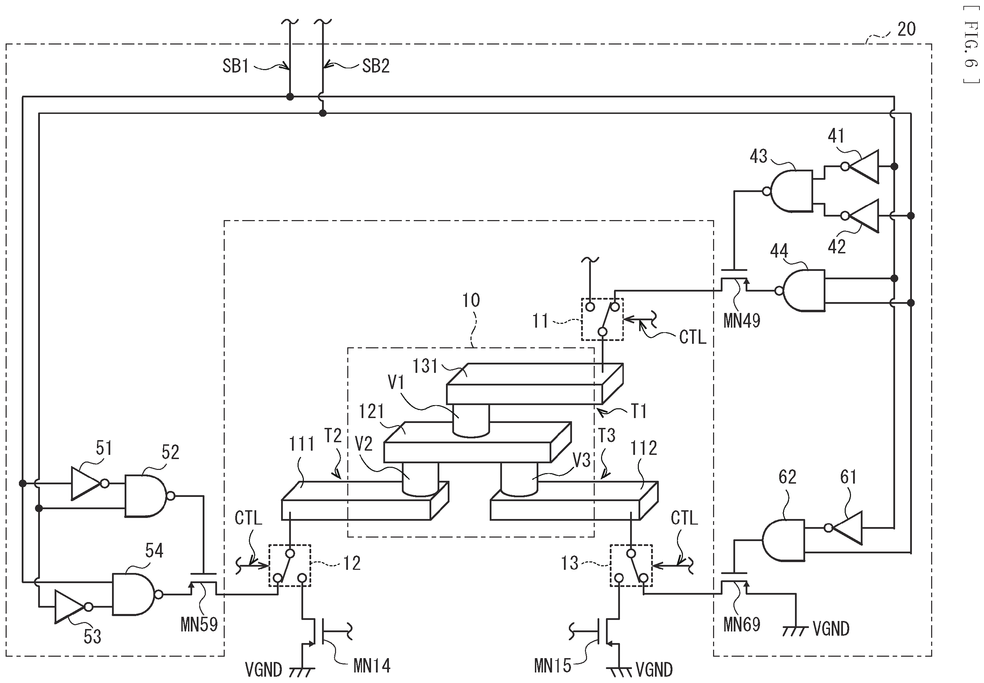

FIG. 6 illustrates a configuration example of the write circuit 20. Note that the storage circuit 10, the switches 11 to 13, and the transistors MN14 and MN15 are also depicted in FIG. 6. The write circuit 20 includes inverters 41 and 42, negative AND circuits (NAND) 43 and 44, a transistor MN49, an inverter 51, a negative AND circuit 52, an inverter 53, a negative AND circuit 54, a transistor MN59, an inverter 61, and an AND circuit (AND) 62. The transistors MN49, MN59, and MN69 are N-type MOS transistors.

The inverter 41 is configured to find negative logic of the signal SB1. The inverter 42 is configured to find negative logic of the signal SB2. The negative AND circuit 43 is configured to find negative AND of an output signal of the inverter 41 and an output signal of the inverter 42. The negative AND circuit 44 is configured to find negative AND of the signal SB1 and the signal SB2. The transistor MN49 has a gate to be supplied with an output signal of the negative AND circuit 43, a source to be supplied with an output signal of the negative AND circuit 44, and a drain coupled to the switch 11.

The inverter 51 is configured to find negative logic of the signal SB1. The negative AND circuit 52 is configured to find negative AND of an output signal of the inverter 51 and the signal SB2. The inverter 53 is configured to find negative logic of the signal SB2. The negative AND circuit 54 is configured to find negative AND of the signal SB1 and an output signal of the inverter 53. The transistor MN59 has a gate to be supplied with an output signal of the negative AND circuit 52, a source to be supplied with an output signal of the negative AND circuit 54, and a drain coupled to the switch 12.

The inverter 61 is configured to find negative logic of the signal SB1. The AND circuit 62 is configured to find logical AND of an output signal of the inverter 61 and the signal SB2. The transistor MN69 has a gate to be supplied with an output signal of the AND circuit 62, a source to which the ground voltage VGND is to be applied, and a drain coupled to the switch 13.

With such a configuration, the write circuit 20 writes data into the storage circuit 10, based on the signals SB1 and SB2 supplied from the control circuit 16.

The read circuit 30 (FIG. 1) is configured to read data stored in the storage circuit 10, based on a control signal supplied from the control circuit 16.

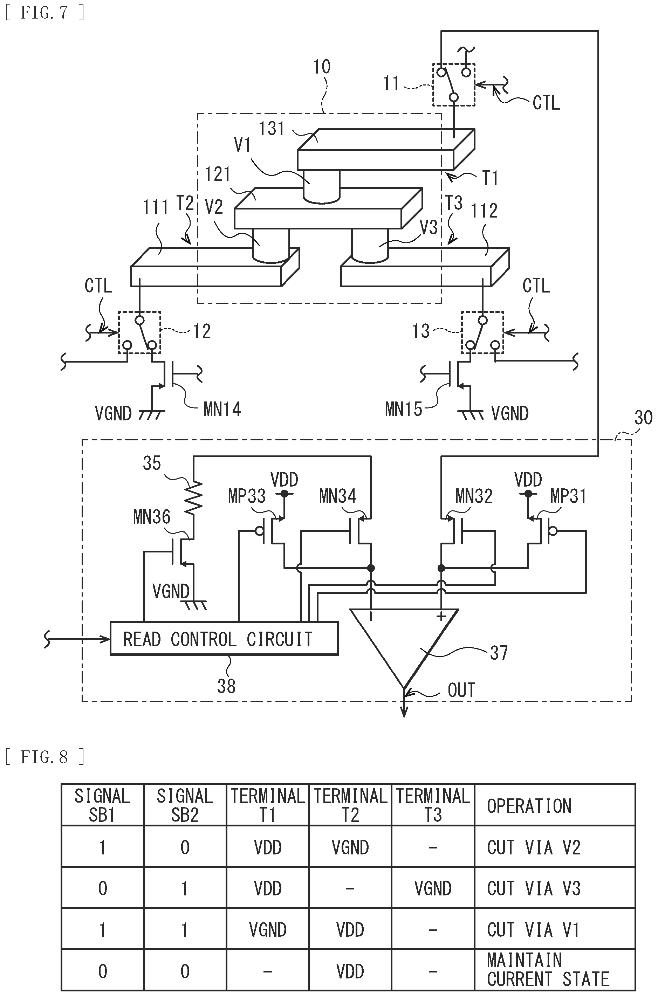

FIG. 7 illustrates a configuration example of the read circuit 30. Note that the storage circuit 10, the switches 11 to 13, and the transistors MN14 and MN15 are also depicted in FIG. 7. The read circuit 30 includes transistors MP31, MN32, MP33, and MN34, a resistor 35, a transistor MN36, a comparator 37, and a read control circuit 38. The transistors MP31 and 33 are P-type MOS transistors, and the transistors MN32, MN34, and MN36 are N-type MOS transistors.

The transistor MP31 has a gate to be supplied with a control signal from the read control circuit 38, a source to be supplied with the power supply voltage VDD, and a drain coupled to a drain of the transistor MN32 and a positive input terminal of the comparator 37. The transistor MN32 has a gate to be supplied with a control signal from the read control circuit 38, the drain coupled to the drain of the transistor MP31 and the positive input terminal of the comparator 37, and a source coupled to the switch 11. The transistor MP33 has a gate to be supplied with a control signal from the read control circuit 38, a source to be supplied with the power supply voltage VDD, and a drain coupled to a drain of the transistor MN34 and a negative input terminal of the comparator 37. The transistor MN34 has a gate to be supplied with a control signal from the read control circuit 38, the drain coupled to the drain of the transistor MP33 and the negative input terminal of the comparator 37, and a source coupled to the resistor 35. The resistor 35 has one end coupled to the source of the transistor MN34, and another end coupled to a drain of the transistor MN36. A resistance value of the resistor 35 is set to, for example, an intermediate value between a resistance value in a case where the vias V1 to V3 are in the high resistance state and a resistance value in a case where vias V1 to V3 are in the low resistance state. The transistor MN36 has a gate to be supplied with a control signal from the read control circuit 38, the drain coupled to the other end of the resistor 35, and a source grounded. The comparator 37 has the positive input terminal coupled to the drains of the transistors MP31 and MN32, and the negative input terminal coupled to the drains of the transistors MP33 and MN34. The comparator 37 compares a voltage at the positive input terminal and a voltage at the negative input terminal, and outputs a result of the comparison as a signal OUT. The read control circuit 38 is configured to control an operation of the read circuit 30 by controlling operations of the transistors MP31, MN32, MP33, MN34, and MN36, based on control signals supplied from the control circuit 16.

With such a configuration, the read circuit 30 reads data stored in the storage circuit 10.

The control circuit 16 (FIG. 1) is configured to control operations of the semiconductor storage device 1, based on signals supplied from outside. Specifically, in a case of receiving a write instruction from outside, the control circuit 16 generates the signals SB1 and SB2, based on writing data included in the write instruction, supplies the signals SB1 and SB2 to the write circuit 20, and controls operations of the switches 11 to 13 to cause the switches 11 to 13 to couple the terminals T1 to T3 of the storage circuit 10 to the write circuit 20. Further, in a case of receiving a read instruction from outside, the control circuit 16 controls the operations of the switches 11 to 13 to cause the switch 11 to couple the terminal T1 of the storage circuit 10 to the read circuit 30, cause the switch 12 to couple the terminal T2 of the storage circuit 10 to the drain of the transistor MN14, and cause the switch 13 to couple the terminal T3 of the storage circuit 10 to the drain of the transistor MN15. In addition, the control circuit 16 controls the operations of the transistors MN14 and MN15 and controls the operation of the read circuit 30.

Here, the via V1 corresponds to a specific example of a "first via" in one embodiment of the present disclosure. The terminal T1 corresponds to a specific example of a "first coupling terminal" in one embodiment of the present disclosure. The node NN corresponds to a specific example of a "coupling node" in one embodiment of the present disclosure. The via V2 corresponds to a specific example of a "second via" in one embodiment of the present disclosure. The terminal T2 corresponds to a specific example of a "second coupling terminal" in one embodiment of the present disclosure. The via V3 corresponds to a specific example of a "third via" in one embodiment of the present disclosure. The terminal T3 corresponds to a specific example of a "third coupling terminal" in one embodiment of the present disclosure. The write circuit 20 corresponds to a specific example of a "write circuit" in one embodiment of the present disclosure. The read circuit 30 corresponds to a specific example of a "read circuit" in one embodiment of the present disclosure. The ground voltage VGND corresponds to a specific example of a "first voltage" in one embodiment of the present disclosure. The power supply voltage VDD corresponds to a specific example of a "second voltage" in one embodiment of the present disclosure. The via layer VL2 corresponds to a specific example of a "first via layer" in one embodiment of the present disclosure. The via layer VL1 corresponds to a specific example of a "second via layer" in one embodiment of the present disclosure. The metal wiring layer ML2 corresponds to a specific example of a "wiring layer" in one embodiment of the present disclosure.

### [Operations and Workings]

Next, a description will be given of operation and workings of the semiconductor storage device 1 according to the present embodiment.

### (Outline of Overall Operation)

First, a description will be given of an outline of an overall operation of the semiconductor storage device 1 with reference to FIG. 1. The storage circuit 10 stores two bits of data. In the case where the semiconductor storage device 1 writes data into the storage circuit 10, the switches 11 to 13 couple the terminals T1 to T3 of the storage circuit 10 to the write circuit 20, based on the control signal CTL. The write circuit 20 writes data into the storage circuit 10, based on the signals SB1 and SB2 supplied from the control circuit 16. In the case where the semiconductor storage device 1 reads data from the storage circuit 10, the switches 11 to 13 couple the terminal T1 of the storage circuit 10 to the read circuit 30, couple the terminal T2 of the storage circuit 10 to the drain of the transistor MN14, and couple the terminal T3 of the storage circuit 10 to the drain of the transistor MN15, based on the control signal CTL. The read circuit 30 reads data stored in the storage circuit 10, based on the control signal supplied from the control circuit 16. The control circuit 16 controls the operation of the semiconductor storage device 1, based on the signal supplied from outside.

### (Detailed Operation)

Next, a detailed description will be given of the write operation of the semiconductor storage device 1.

FIG. 8 illustrates an example of the write operation of the semiconductor storage device 1. In FIG. 8, "VDD" represents applying the power supply voltage VDD to a terminal, "VGND" represents applying the ground voltage VGND to a terminal, and "-" represents bringing a terminal into the floating state.

For example, in a case where the signal SB1 is "1" and the signal SB2 is "0", the write circuit 20 applies the power supply voltage VDD to the terminal T1, applies the ground voltage VGND to the terminal T2, and brings the terminal T3 into the floating state, as illustrated in FIG. 8.

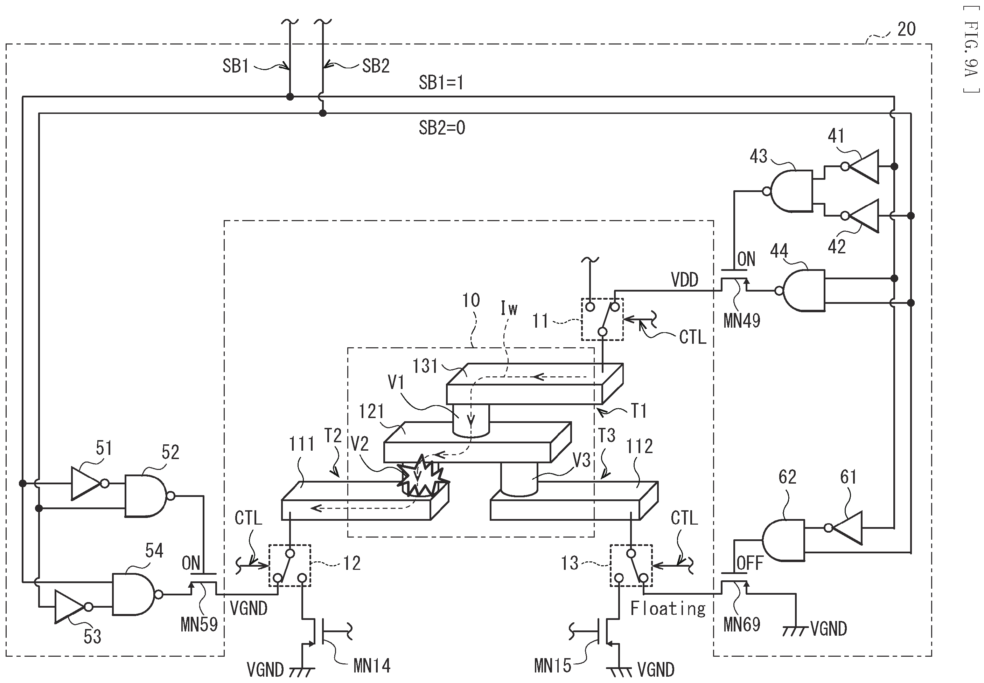

FIG. 9A illustrates an example operation of the write circuit 20 in the case where the signal SB1 is "1" and the signal SB2 is "0". In the write operation, the control circuit 16 controls the operations of the switches 11 to 13 to cause the switches 11 to 13 to couple the terminals T1 to T3 of the storage circuit 10 to the write circuit 20.

In the case where the signal SB1 is "1" and the signal SB2 is "0", the negative AND circuit 43 outputs a high level voltage, and accordingly, the transistor MN49 comes into an ON state, and the power supply voltage VDD outputted from the negative AND circuit 44 is applied to the terminal T1 of the storage circuit 10 through the transistor MN49 and the switch 11. Further, the negative AND circuit 52 outputs a high level voltage, and accordingly, the transistor MN59 comes into the ON state, and the ground voltage VGND outputted from the negative AND circuit 54 is applied to the terminal T2 of the storage circuit 10 through the transistor MN59 and the switch 12. Further, the AND circuit 62 outputs a low level voltage, and accordingly, the transistor MN69 comes into an OFF state, and the terminal T3 comes into the floating state. In this way, the write circuit 20 applies the power supply voltage VDD to the terminal T1, applies the ground voltage VGND to the terminal T2, and brings the terminal T3 into the floating state.

Accordingly, the write current Iw flows through the wiring 131, the via V1, the wiring 121, the via V2, and the wiring 111 in this order. The via V2 is thus broken and the resistance state of the via V2 is set to the high resistance state. At this time, the resistance value in the path coupling the terminal T1 and the terminal T2 to each other is high, and the resistance value in the path coupling the terminal T1 and the terminal T3 to each other is low. In this way, the bit B1 is set to "1" and the bit B2 is set to "0".

For example, in a case where the signal SB1 is "0" and the signal SB2 is "1", the write circuit 20 applies the power supply voltage VDD to the terminal T1, brings the terminal T2 into the floating state, and applies the ground voltage VGND to the terminal T3, and as illustrated in FIG. 8.

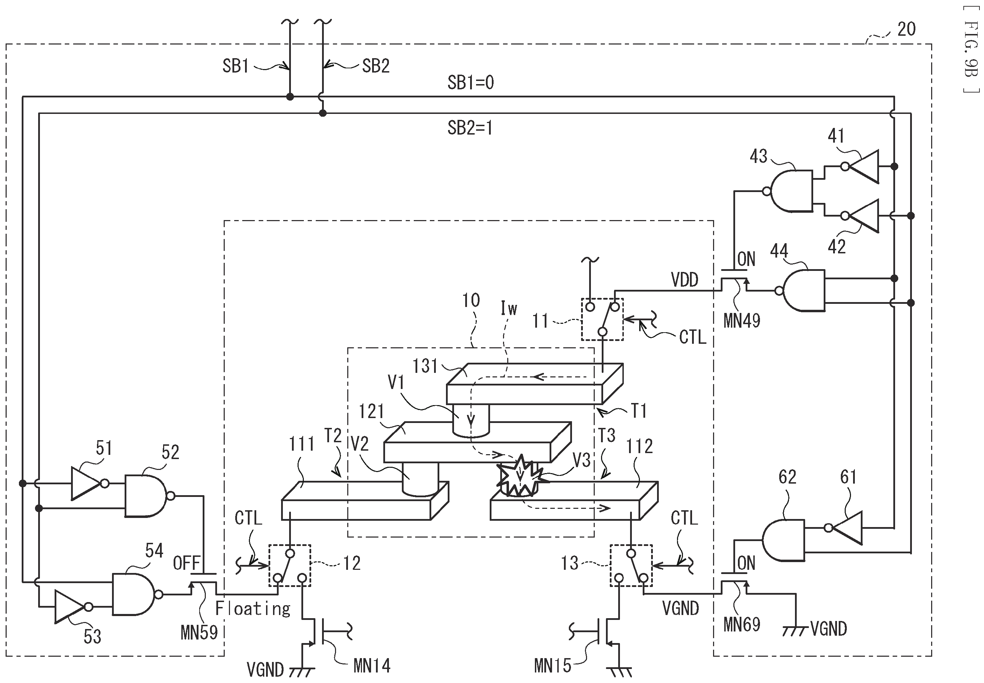

FIG. 9B illustrates an example operation of the write circuit 20 in the case where the signal SB1 is "0" and the signal SB2 is "1".

In the case where the signal SB1 is "0" and the signal SB2 is "1", the negative AND circuit 43 outputs the high level voltage, and accordingly, the transistor MN49 comes into the ON state, and the power supply voltage VDD outputted from the negative AND circuit 44 is applied to the terminal T1 of the storage circuit 10 through the transistor MN49 and the switch 11. Further, the negative AND circuit 52 outputs the low level voltage, and accordingly, the transistor MN59 comes into the OFF state, and the terminal T2 comes into the floating state. Further, the AND circuit 62 outputs a high level voltage, and accordingly, the transistor MN69 comes into the ON state, and the ground voltage VGND is applied to the terminal T3 of the storage circuit 10 through the transistor MN69 and the switch 13. In this way, the write circuit 20 applies the power supply voltage VDD to the terminal T1, brings the terminal T2 into the floating state, and applies the ground voltage VGND to the terminal T3.

Accordingly, the write current Iw flows through the wiring 131, the via V1, the wiring 121, the via V3, and the wiring 112 in this order. The via V3 is thus broken and the resistance state of the via V3 is set to the high resistance state. At this time, the resistance value in the path coupling the terminal T1 and the terminal T2 to each other is low, and the resistance value in the path coupling the terminal T1 and the terminal T3 to each other is high. In this way, the bit B1 is set to "0" and the bit B2 is set to "1".

For example, in a case where the signal SB1 is "1" and the signal SB2 is "1", the write circuit 20 applies the ground voltage VGND to the terminal T1, applies the power supply voltage VDD to the terminal T2, and brings the terminal T3 into the floating state, as illustrated in FIG. 8.

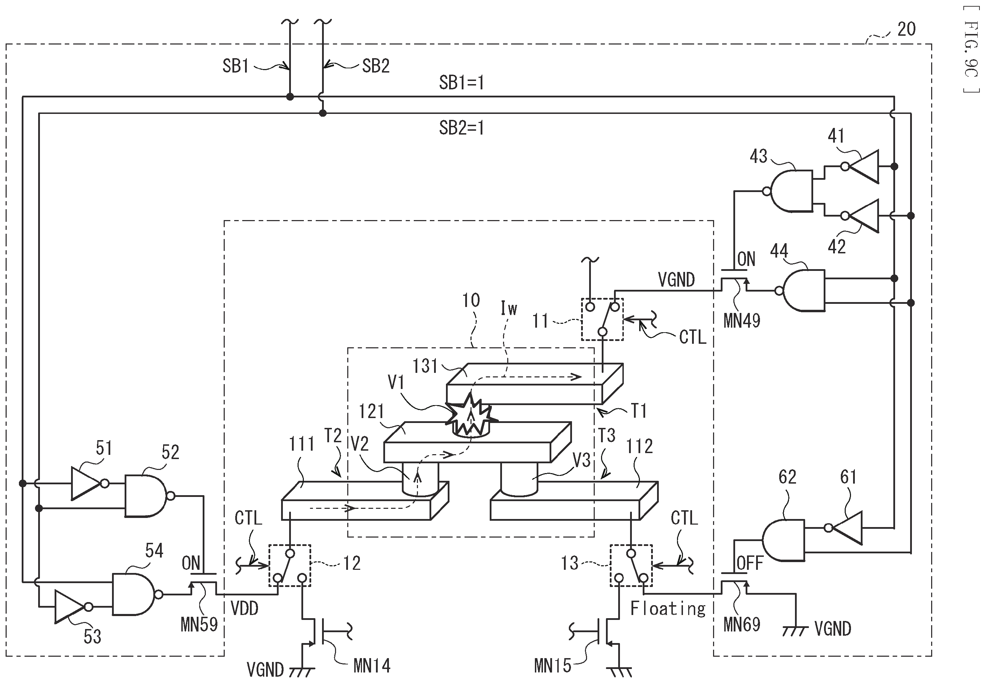

FIG. 9C illustrates an example operation of the write circuit 20 in the case where the signal SB1 is "1" and the signal SB2 is "1".

In the case where the signals SB1 and SB2 are both "1", the negative AND circuit 43 outputs the high level voltage, and accordingly, the transistor MN49 comes into the ON state, and the ground voltage VGND outputted from the negative AND circuit 44 is applied to the terminal T1 of the storage circuit 10 through the transistor MN49 and the switch 11. Further, the negative AND circuit 52 outputs the high level voltage, and accordingly, the transistor MN59 comes into the ON state, and the power supply VDD outputted from the negative AND circuit 54 is applied to the terminal T2 of the storage circuit 10 through the transistor MN59 and the switch 12. Further, the AND circuit 62 outputs the low level voltage, and accordingly, the transistor MN69 comes into the OFF state, and the terminal T3 comes into the floating state. In this way, the write circuit 20 applies the ground voltage VGND to the terminal T1, applies the power supply voltage VDD to the terminal T2, and brings the terminal T3 into the floating state.

Accordingly, the write current Iw flows through the wiring 111, the via V2, the wiring 121, the via V3, and the wiring 131 in this order. The via V1 is thus broken and the resistance state of the via V1 is set to the high resistance state. At this time, the resistance value in the path coupling the terminal T1 and the terminal T2 to each other and the resistance value in the path coupling the terminal T1 and the terminal T3 to each other are both high. In this way, the bits B1 and B2 are both set to "1".

In a case where the signal SB1 is "0" and the signal SB2 is "0", the write circuit 20 brings the terminal T1 into the floating state, applies the power supply voltage VDD to the terminal T2, and brings the terminal T3 into the floating state, as illustrated in FIG. 8. In this case, no write current Iw flows and therefore the resistance states of the vias V1 to V3 are maintained.

As described above, in a case of setting both the bits B1 and B2 to "1", the write circuit 20 sets the resistance state of the via V1 to the high resistance state, as illustrated in FIGs. 4C and 9C. That is, the write circuit 20 sets the resistance state of the via V1 to the high resistance state as illustrated in FIGs. 4C and 9C, without setting the resistance states of both the vias V2 and V3 to the high resistance state by sequentially performing the operation illustrated in FIGs. 4A and 9A and the operation illustrated in FIGs. 4B and 9B, for example. This makes it possible for the semiconductor storage device 1 to set both the bits B1 and B2 to "1" in one write operation. As a result, it is possible for the semiconductor storage device 1 to reduce power consumption while shortening writing time in the write operation.

Next, a detailed description will be given of the read operation of the semiconductor storage device 1.

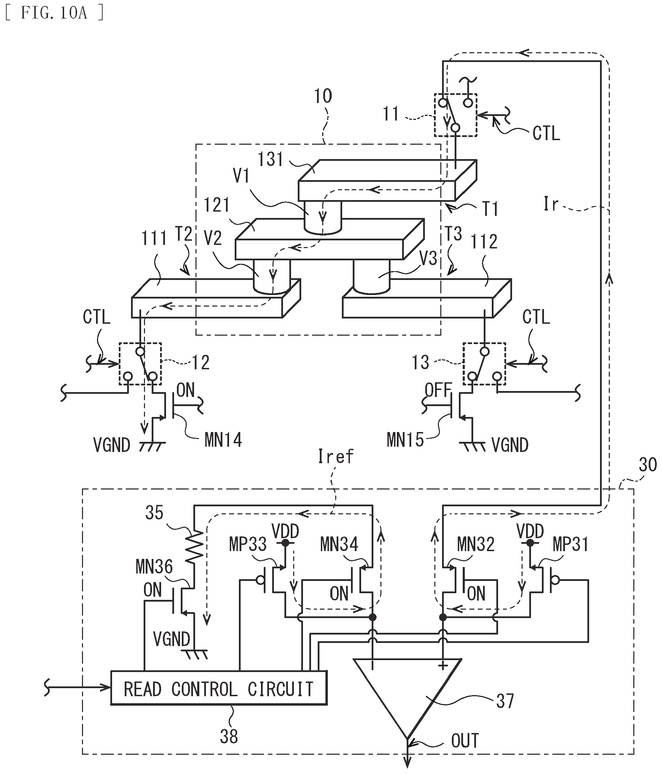

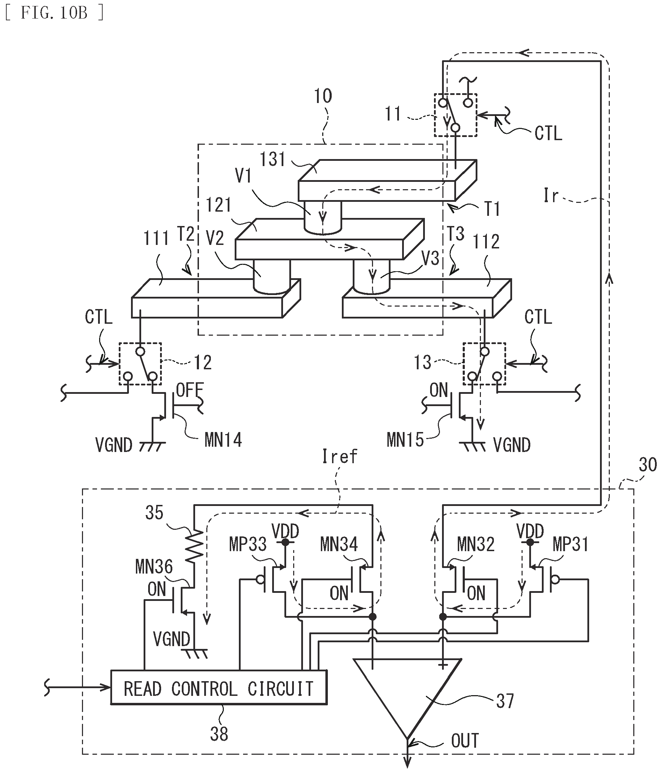

FIG. 10A illustrates an example operation of reading the bit B1 in the semiconductor storage device 1. FIG. 10B illustrates an example operation of reading the bit B2 in the semiconductor storage device 1. In the read operation, the control circuit 16 controls the operations of the switches 11 to 13 to cause the switch 11 to couple the terminal T1 of the storage circuit 10 to the read circuit 30, cause the switch 12 to couple the terminal T2 of the storage circuit 10 to the drain of the transistor MN14, and cause the switch 13 to couple the terminal T3 of the storage circuit 10 to the drain of the transistor MN15. Further, in the read circuit 30, based on instructions from the control circuit 16, the read control circuit 38 brings the transistors MN32, MN34, and MN36 into the ON state and sets gate voltages of the transistors MP31 and MP33 to a predetermined voltage at which the transistors MP31 and MP33 are each operable as a current source. A current value of a current (a read current Ir) that the transistor MP31 allows to flow and a current value of a current (a reference current Iref) that the transistor MP33 allows to flow are equal to each other.

In a case of reading data of the bit B1, as illustrated in FIG. 10A, the control circuit 16 brings the transistor MN14 into the ON state and brings the transistor MN15 into the OFF state. In the semiconductor storage device 1, the reference current Iref flows through the transistor MP33, the transistor MN34, the resistor 35, and the transistor MN36 in this order, and the read current Ir flows through the transistor MP31, the transistor MN32, the switch 11, the wiring 131, the via V1, the wiring 121, the via V2, the wiring 111, the switch 12, and the transistor MN14 in this order. A voltage corresponding to the resistance value of the resistor 35 is generated at the negative input terminal of the comparator 37, and a voltage corresponding to the resistance value in the path coupling the terminal T1 and the terminal T2 to each other is generated at the positive input terminal of the comparator 37. For example, in a case where the bit B1 is "1", the resistance state of either the via V1 or the via V2 is at the high resistance state, and accordingly, the voltage at the positive input terminal of the comparator 37 is higher than the voltage at the negative input terminal of the comparator 37. The signal OUT outputted from the comparator 37 is therefore at a high level ("1"). For example, in a case where the bit B1 is "0", the resistance states of both the via V1 or the via V2 are at the low resistance state, and accordingly, the voltage at the positive input terminal of the comparator 37 is lower than the voltage at the negative input terminal of the comparator 37. The signal OUT outputted from the comparator 37 is therefore at a low level ("0").

Similarly, in a case of reading data of the bit B2, as illustrated in FIG. 10B, the control circuit 16 brings the transistor MN15 into the ON state and brings the transistor MN14 into the OFF state. In the semiconductor storage device 1, the reference current Iref flows through the transistor MP33, the transistor MN34, the resistor 35, and the transistor MN36 in this order, and the read current Ir flows through the transistor MP31, the transistor MN32, the switch 11, the wiring 131, the via V1, the wiring 121, the via V3, the wiring 112, the switch 13, and the transistor MN15 in this order. A voltage corresponding to the resistance value of the resistor 35 is generated at the negative input terminal of the comparator 37, and a voltage corresponding to the resistance value in the path coupling the terminal T1 and the terminal T3 to each other is generated at the positive input terminal of the comparator 37. For example, in a case where the bit B2 is "1", the resistance state of either the via V1 or the via V3 is at the high resistance state, and accordingly, the voltage at the positive input terminal of the comparator 37 is higher than the voltage at the negative input terminal of the comparator 37. The signal OUT outputted from the comparator 37 is therefore at the high level ("1"). For example, in a case where the bit B2 is "0", the resistance states of both the via V1 or the via V3 are at the low resistance state, and accordingly, the voltage at the positive input terminal of the comparator 37 is lower than the voltage at the negative input terminal of the comparator 37. The signal OUT outputted from the comparator 37 is therefore at the low level ("0").

In this way, it is possible for the read circuit 30 to read two bits of data stored in the storage circuit 10.

As has been described, the semiconductor storage device 1 includes: the first via (the via V1) provided in a path coupling the first coupling terminal (the terminal T1) and the coupling node (the node NN) to each other, the first via being configured to irreversibly come into the high resistance state by passage of current therethrough; the second via (the via V2) provided in a path coupling the coupling node (the node NN) and the second coupling terminal (the terminal T2) to each other, the second via being configured to irreversibly come into the high resistance state by passage of current therethrough; the third via (the via V3) provided in a path coupling the coupling node (the node NN) and the third coupling terminal (the terminal T3) to each other, the third via being configured to irreversibly come into the high resistance state by passage of current therethrough; and the write circuit 20 coupled to the first coupling terminal (the terminal T1), the second coupling terminal (the terminal T2), and the third coupling terminal (the terminal T3), the write circuit 20 being configured to allow the write current Iw to flow bidirectionally between the first coupling terminal and the second coupling terminal, and configured to allow the write current Iw to flow bidirectionally between the first coupling terminal and the third coupling terminal. This makes it possible for the semiconductor storage device 1 to selectively set the resistance state of any one of the vias V1 to V3 to the high resistance state. For example, in a case where the resistance state of the via V1 is set to the high resistance state, it is possible to set both the bit B1 and the bit B2 to "1". This makes it possible to reduce power consumption while shortening the writing time, as compared with a case of sequentially performing the operation of setting the resistance state of the via V2 to the high resistance state and the operation of setting the resistance state of the via V3 to the high resistance state.

Further, in the semiconductor storage device 1, the first via (the via V1) is configured to come into the high resistance state in a case where the write current Iw flows in one of a first direction from the first coupling terminal (the terminal T1) toward the second coupling terminal (the terminal T2) and a second direction from the second coupling terminal (the terminal T2) toward the first coupling terminal (the terminal T1), and the second via (the via V2) is configured to come into the high resistance state in a case where the write current Iw flows in another one of the first direction and the second direction. Owing to this, as illustrated in FIGs. 4A and 9A, for example, in the case where the write current Iw flows from the terminal T1 toward the terminal T2, it is possible to set the resistance state of the via V2 to the high resistance state and to set the bit B1 to "1". Further, in the case where the write current Iw flows from the terminal T2 toward the terminal T1, it is possible to set the resistance state of the via V1 to the high resistance state and to set both the bits B1 and B2 to "1". By setting the resistance state of the via V1 to the high resistance state in this way, it is possible to reduce power consumption while shortening the writing time.

Further, in the semiconductor storage device 1, the write circuit 20 is configured to bring the first via (the via V1) into the high resistance state by applying the first voltage (for example, the ground voltage VGND) to the first coupling terminal (the terminal T1) and applying the second voltage (for example, the power supply voltage VDD) to the second coupling terminal (the terminal T2). Further, the write circuit 20 is configured to bring the second via (the via V2) into the high resistance state by applying the second voltage (for example, the power supply voltage VDD) to the first coupling terminal (the terminal T1) and applying the first voltage (for example, the ground voltage VGND) to the second coupling terminal (the terminal T2). Further, the write circuit 20 is configured to bring the third via (the via V3) into the high resistance state by applying the second voltage (for example, the power supply voltage VDD) to the first coupling terminal (the terminal T1) and applying the first voltage (for example, the ground voltage VGND) to the third coupling terminal (the terminal T3). Owing to this, for example, in the case where the resistance state of the via V1 is set to the high resistance state, it is possible to set both the bit B1 and the bit B2 to "1". This makes it possible to reduce power consumption while shortening the writing time.

### [Effects]

As described above, in the present embodiment, there are provided: a first via provided in a path coupling a first coupling terminal and a coupling node to each other, the first via being configured to irreversibly come into a high resistance state by passage of current therethrough; a second via provided in a path coupling the coupling node and a second coupling terminal to each other, the second via being configured to irreversibly come into a high resistance state by passage of current therethrough; a third via provided in a path coupling the coupling node and a third coupling terminal to each other, the third via being configured to irreversibly come into a high resistance state by passage of current therethrough; and a write circuit coupled to the first coupling terminal, the second coupling terminal, and the third coupling terminal, the write circuit being configured to allow a write current to flow bidirectionally between the first coupling terminal and the second coupling terminal, and configured to allow the write current to flow bidirectionally between the first coupling terminal and the third coupling terminal. This makes it possible to reduce power consumption while shortening the writing time.

In the present embodiment, the first via is configured to come into the high resistance state in a case where the write current flows in one of a first direction from the first coupling terminal toward the second coupling terminal and a second direction from the second coupling terminal toward the first coupling terminal, and the second via is configured to come into the high resistance state in a case where the write current flows in another one of the first direction and the second direction. This makes it possible to reduce power consumption while shortening the writing time.

In the present embodiment, the write circuit is configured to bring the first via into the high resistance state by applying a first voltage to the first coupling terminal and applying a second voltage to the second coupling terminal. Further, the write circuit is configured to bring the second via into the high resistance state by applying the second voltage to the first coupling terminal and applying the first voltage to the second coupling terminal. Further, the write circuit is configured to bring the third via into the high resistance state by applying the second voltage to the first coupling terminal and applying the first voltage to the third coupling terminal. This makes it possible to reduce power consumption while shortening the writing time.

### [Modification Example 1]

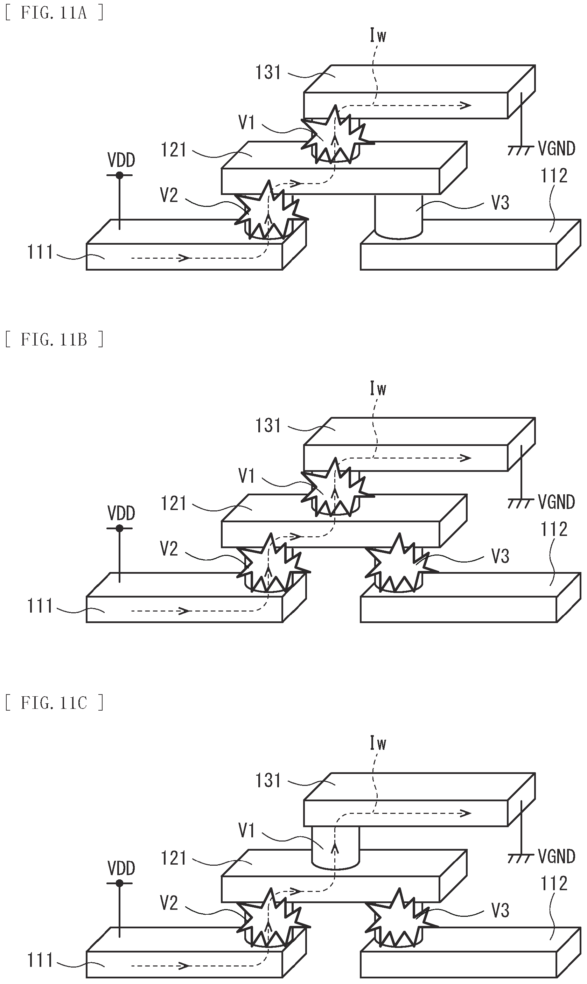

In the foregoing embodiment, as illustrated in FIG. 4C, only the via V1 is broken in the case where the ground voltage VGND is applied to the wiring 131, where the power supply voltage VDD is applied to the wiring 111, and where the wiring 112 is in the floating state; however, this is non-limiting. Alternatively, for example, both the via V1 and the via V2 may be broken as illustrated in FIG. 11A, all of the vias V1 to V3 may be broken as illustrated in FIG. 11B, or the vias V2 and V3 may be broken as illustrated in FIG. 11C. Even in any of these three cases, the resistance value in the path coupling the terminal T1 and the terminal T2 to each other and the resistance value in the path coupling the terminal T1 and the terminal T3 to each other are both high, and therefore it is possible to set both the bit B1 and the bit B2 to "1".

### [Modification Example 2]

In the foregoing embodiment, as illustrated in FIGs. 4A and 4C, for example, the via V2 is broken in the case where the power supply voltage VDD is applied to the wiring 131, where the ground voltage VGND is applied to the wiring 111, and where the wiring 112 is in a floating state, and the via V1 is broken in the case where the ground voltage VGND is applied to the wiring 131, where the power supply voltage VDD is applied to the wiring 111, and where the wiring 112 is in the floating state; however, this is non-limiting. The present modification example will be described in detail below with reference to specific examples.

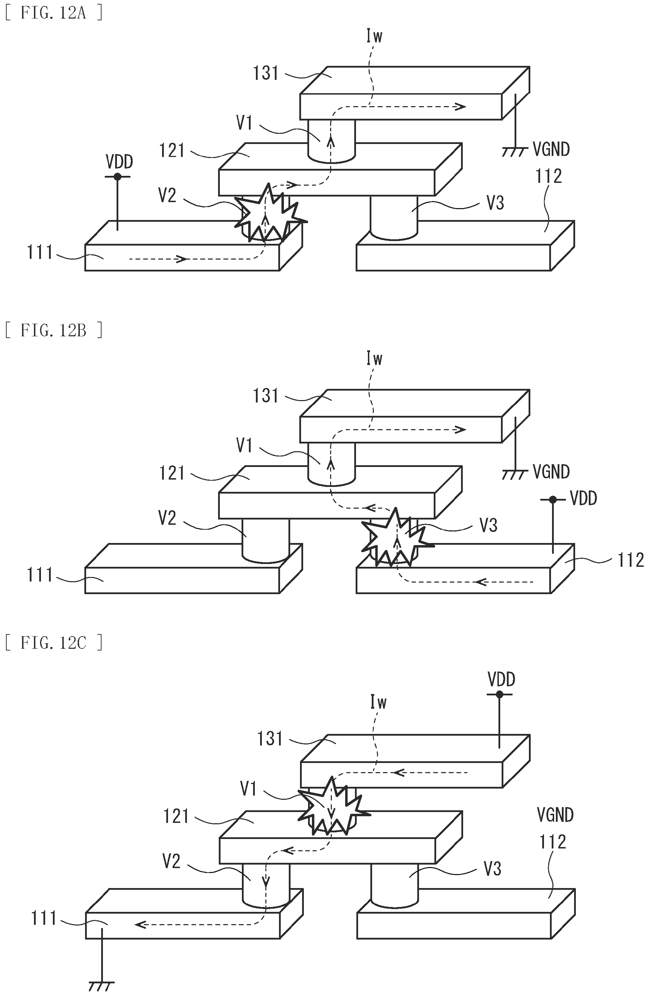

FIGs. 12A to 12C illustrate an example of data write operation in a storage circuit 10B according to the present modification example.

For example, as illustrated in FIG. 12A, in the case where the ground voltage VGND is applied to the wiring 131, where the power supply voltage VDD is applied to the wiring 111, and where the wiring 112 is in the floating state, the write current Iw flows through the wiring 111, the via V2, the wiring 121, the via V1, and the wiring 131 in this order. In such a case, in this example, the via V2 is broken and the resistance state of the via V2 is set to the high resistance state.

Further, for example, as illustrated in FIG. 12B, in a case where the ground voltage VGND is applied to the wiring 131, where the wiring 111 is in the floating state, and where the power supply voltage VDD is applied to the wiring 112, the write current Iw flows through the wiring 112, the via V3, the wiring 121, the via V1, and the wiring 131 in this order. In such a case, in this example, the via V3 is broken and the resistance state of the via V3 is set to the high resistance state.

Further, for example, as illustrated in FIG. 12C, in the case where the power supply voltage VDD is applied to the wiring 131, where the ground voltage VGND is applied to the wiring 111, and where the wiring 112 is in the floating state, the write current Iw flows through the wiring 131, the via V1, the wiring 121, the via V2, and the wiring 111 in this order. In such a case, in this example, the via V1 is broken and the resistance state of the via V1 is set to the high resistance state.

In this example, as illustrated in FIGs. 12A and 12B, in the case where the write current Iw flows from the wiring 111 or the wiring 112 in the metal wiring layer ML1 toward the wiring 131 in the metal wiring layer ML3, the via V1 in the via layer VL2 is not broken but the via V2 or the via V3 in the via layer VL1 is broken. Further, as illustrated in FIG. 4C, in the case where the write current Iw flows from the wiring 131 in the metal wiring layer ML3 toward the wiring 111 or the wiring 112 in the metal wiring layer ML1, neither of the vias V2 and V3 in the via layer VL1 is broken but the via V1 in the via layer VL2 is broken.

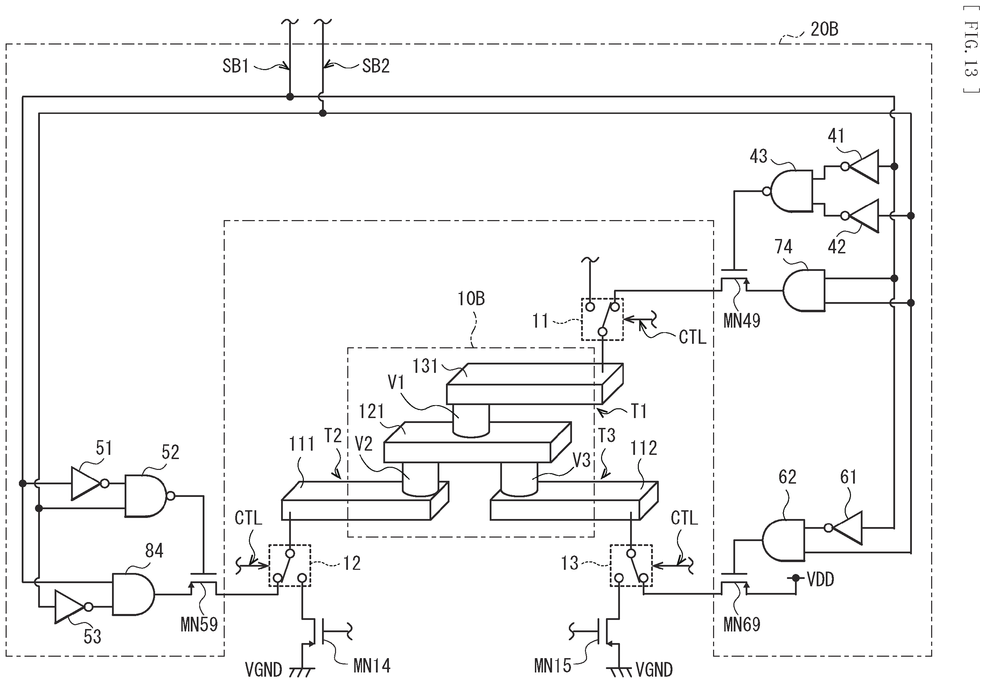

FIG. 13 illustrates a configuration example of a write circuit 20B according to the present modification example. Note that the storage circuit 10B, the switches 11 to 13, and the transistors MN14 and MN15 are also depicted in FIG. 13. The write circuit 20B includes AND circuits 74 and 84. The AND circuit 74 is configured to find logical AND of the signal SB1 and the signal SB2. The transistor MN49 has the gate to be supplied with the output signal of the negative AND circuit 43, the source to be supplied with an output signal of the AND circuit 74, and the drain coupled to the switch 11. The AND circuit 84 is configured to find logical AND of the signal SB1 and the output signal of the inverter 53. The transistor MN59 has the gate to be supplied with the output signal of the negative AND circuit 52, the source to be supplied with an output signal of the AND circuit 84, and a drain coupled to the switch 12. The transistor MN69 has the gate to be supplied with the output signal of the AND circuit 62, the source to be supplied with the power supply voltage VDD, and the drain coupled to the switch 13.

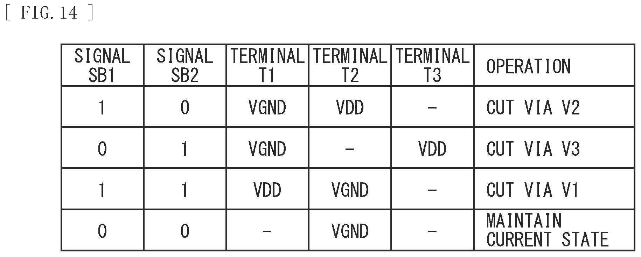

FIG. 14 illustrates an example of the write operation according to the present modification example.

For example, in the case where the signal SB1 is "1" and the signal SB2 is "0", the write circuit 20B applies the ground voltage VGND to the terminal T1, applies the power supply voltage VDD to the terminal T2, and brings the terminal T3 into the floating state, as illustrated in FIG. 14.

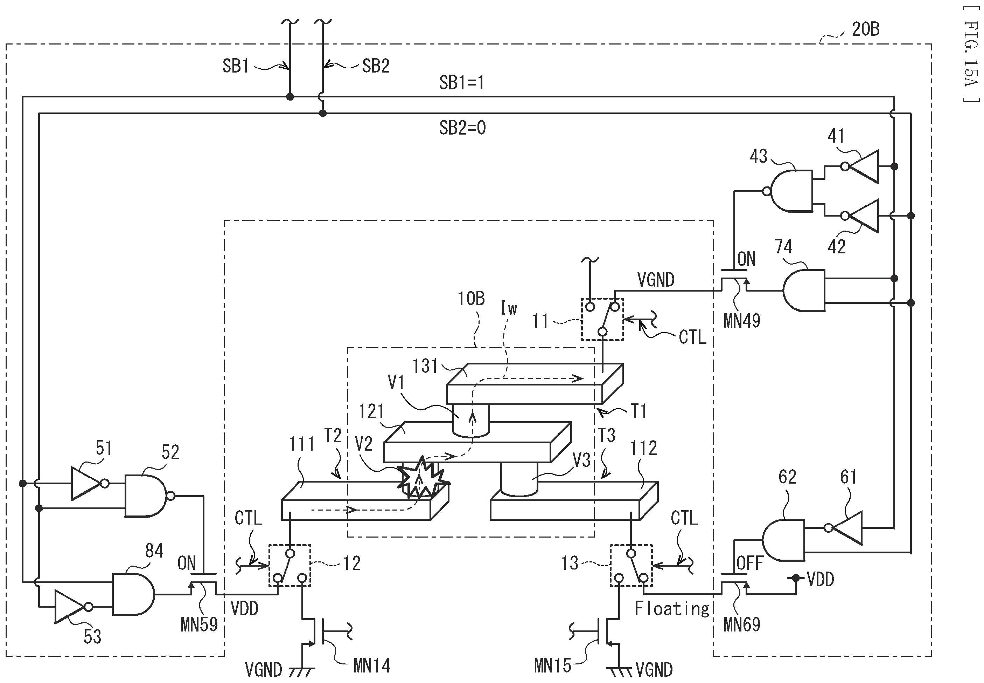

FIG. 15A illustrates an example operation of the write circuit 20B in the case where the signal SB1 is "1" and the signal SB2 is "0".

In the case where the signal SB1 is "1" and the signal SB2 is "0", the negative AND circuit 43 outputs the high level voltage, and accordingly, the transistor MN49 comes into the ON state, and the ground voltage VGND outputted from the AND circuit 74 is applied to the terminal T1 of the storage circuit 10B through the transistor MN49 and the switch 11. Further, the negative AND circuit 52 outputs the high level voltage, and accordingly, the transistor MN59 comes into the ON state, and the power supply voltage VDD outputted from the AND circuit 84 is applied to the terminal T2 of the storage circuit 10B through the transistor MN59 and the switch 12. Further, the AND circuit 62 outputs the low level voltage, and accordingly, the transistor MN69 comes into the OFF state, and the terminal T3 comes into the floating state. In this way, the write circuit 20B applies the ground voltage VGND to the terminal T1, applies the power supply voltage VDD to the terminal T2, and brings the terminal T3 into the floating state.

Accordingly, the write current Iw flows through the wiring 111, the via V2, the wiring 121, the via V1, and the wiring 131 in this order. The via V2 is thus broken and the resistance state of the via V2 is set to the high resistance state. At this time, the resistance value in the path coupling the terminal T1 and the terminal T2 to each other is high, and the resistance value in the path coupling the terminal T1 and the terminal T3 to each other is low. In this way, the bit B1 is set to "1" and the bit B2 is set to "0".

For example, in the case where the signal SB1 is "0" and the signal SB2 is "1", the write circuit 20B applies the ground voltage VGND to the terminal T1, brings the terminal T2 into the floating state, and applies the power supply voltage VDD to the terminal T3, as illustrated in FIG. 14.

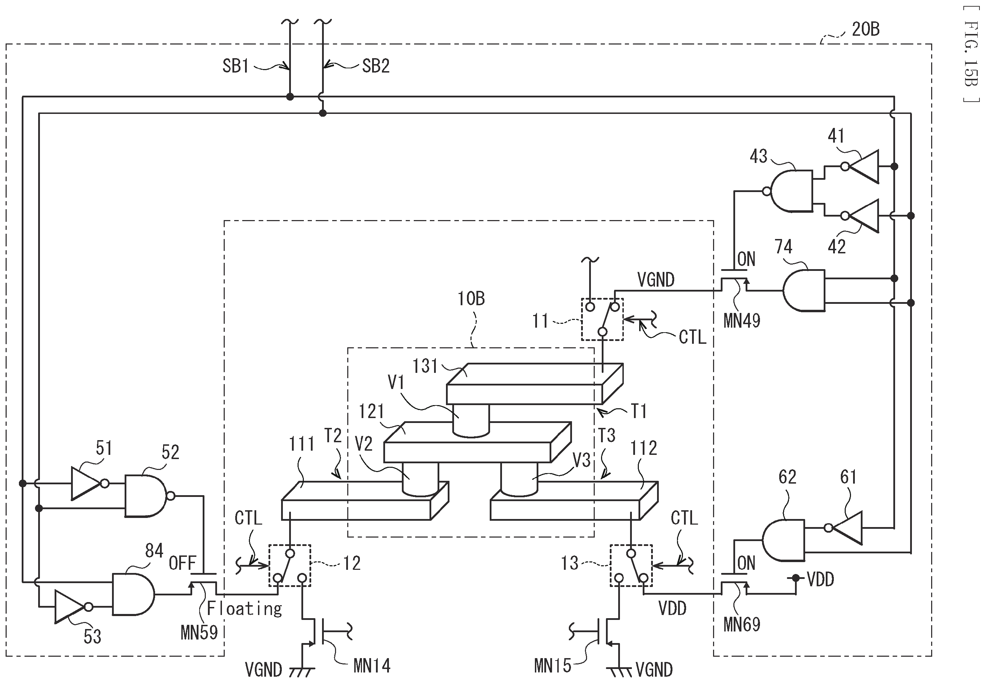

FIG. 15B illustrates an example operation of the write circuit 20B in the case where the signal SB1 is "0" and the signal SB2 is "1".

In the case where the signal SB1 is "0" and the signal SB2 is "1", the negative AND circuit 43 outputs the high level voltage, and accordingly, the transistor MN49 comes into the ON state, and the ground voltage VGND outputted from the AND circuit 74 is applied to the terminal T1 of the storage circuit 10B through the transistor MN49 and the switch 11. Further, the negative AND circuit 52 outputs the low level voltage, and accordingly, the transistor MN59 comes into the OFF state, and the terminal T2 comes into the floating state. Further, the AND circuit 62 outputs the high level voltage, and accordingly, the transistor MN69 comes into the ON state, and the power supply voltage VDD is applied to the terminal T3 of the storage circuit 10B through the transistor MN69 and the switch 13. In this way, the write circuit 20B applies the ground voltage VGND to the terminal T1, brings the terminal T2 into the floating state, and applies the power supply voltage VDD to the terminal T3.

Accordingly, the write current Iw flows through the wiring 112, the via V3, the wiring 121, the via V1, and the wiring 131 in this order. The via V3 is thus broken and the resistance state of the via V3 is set to the high resistance state. At this time, the resistance value in the path coupling the terminal T1 and the terminal T2 to each other is low, and the resistance value in the path coupling the terminal T1 and the terminal T3 to each other is high. In this way, the bit B1 is set to "0" and the bit B2 is set to "1".

For example, in the case where the signal SB1 is "1" and the signal SB2 is "1", the write circuit 20B applies the power supply voltage VDD to the terminal T1, applies the ground voltage VGND to the terminal T2, and brings the terminal T3 into the floating state, as illustrated in FIG. 14.

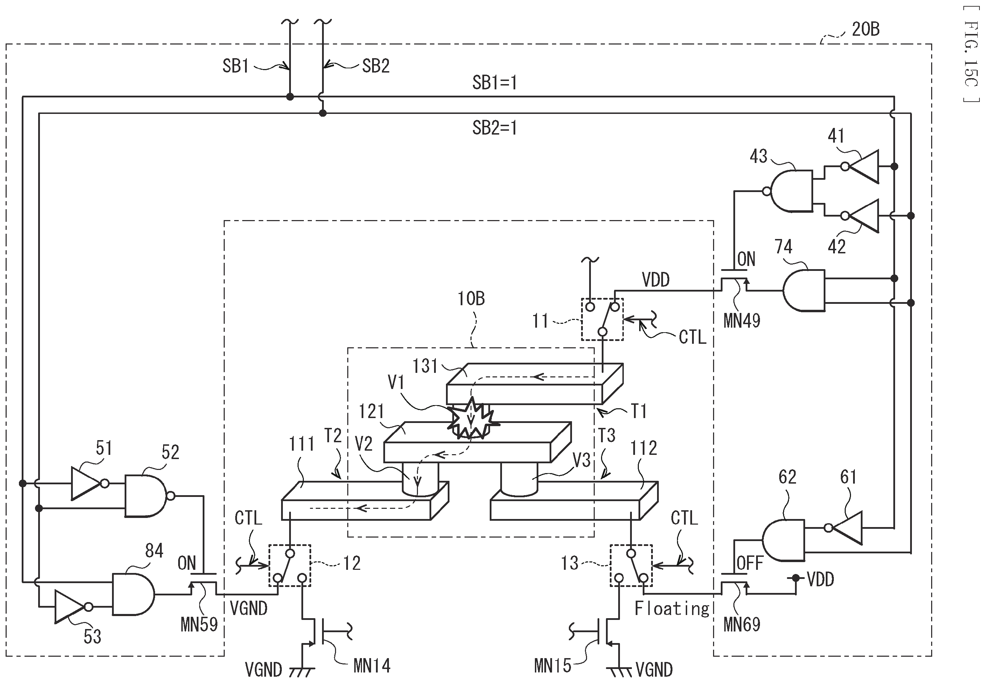

FIG. 15C illustrates an example operation of the write circuit 20B in the case where the signal SB1 is "1" and the signal SB2 is "1".

In the case where the signals SB1 and SB2 are both "1", the negative AND circuit 43 outputs the high level voltage, and accordingly, the transistor MN49 comes into the ON state, and the power supply voltage VDD outputted from the AND circuit 74 is applied to the terminal T1 of the storage circuit 10B through the transistor MN49 and the switch 11. Further, the negative AND circuit 52 outputs the high level voltage, and accordingly, the transistor MN59 comes into the ON state, and the ground voltage VGND outputted from the AND circuit 84 is applied to the terminal T2 of the storage circuit 10B through the transistor MN59 and the switch 12. Further, the AND circuit 62 outputs the low level voltage, and accordingly, the transistor MN69 comes into the OFF state, and the terminal T3 comes into the floating state. In this way, the write circuit 20B applies the power supply voltage VDD to the terminal T1, applies the ground voltage VGND to the terminal T2, and brings the terminal T3 into the floating state.

Accordingly, the write current Iw flows through the wiring 131, the via V1, the wiring 121, the via V1, and the wiring 111 in this order. The via V1 is thus broken and the resistance state of the via V1 is set to the high resistance state. At this time, the resistance value in the path coupling the terminal T1 and the terminal T2 to each other and the resistance value in the path coupling the terminal T1 and the terminal T3 to each other are both high. In this way, the bits B1 and B2 are both set to "1".

For example, in the case where the signal SB1 is "0" and the signal SB2 is "0", the write circuit 20B brings the terminal T1 into the floating state, applies the ground voltage VGND to the terminal T2, and brings the terminal T3 into the floating state, as illustrated in FIG. 14. In this case, no write current Iw flows and therefore the resistance states of the vias V1 to V3 are maintained.

### [Modification Example 3]

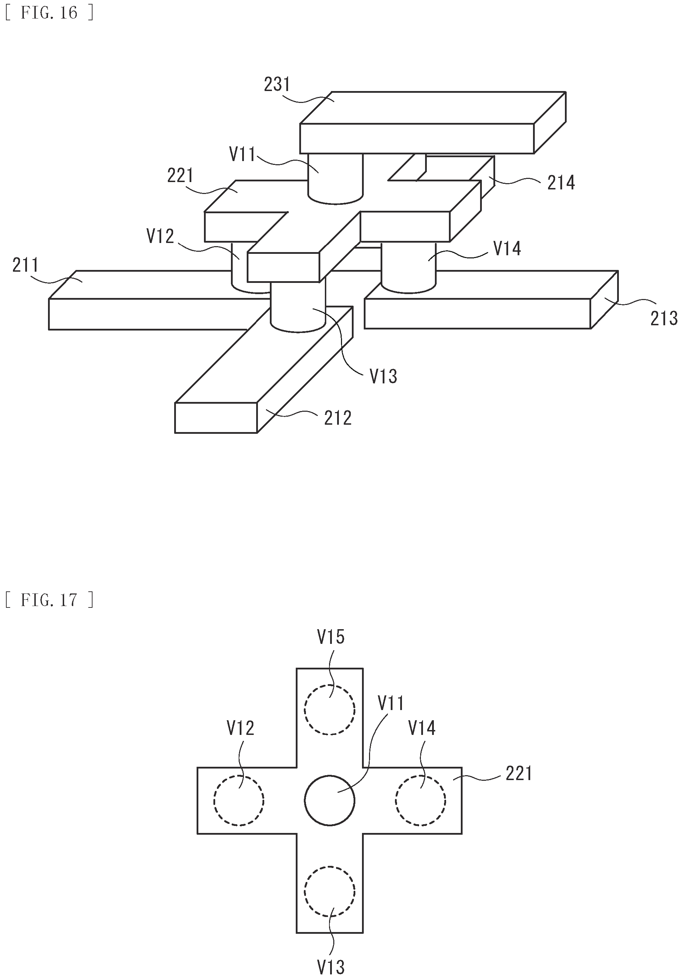

In the foregoing embodiment, the two vias V2 and V3 are provided in the via layer VL1; however, this is non-limiting. Alternatively, for example, three or more vias may be provided. FIGs. 16 and 17 illustrate an example case where four vias are provided in the via layer VL1. The storage circuit 10 according to the present modification example includes vias V11 to V15, wirings 211 to 214, 221, and 231. The wiring 231 is provided in the metal wiring layer ML3. The via V11 is provided in the via layer VL2. The wiring 221 is provided in the metal wiring layer ML2. The vias V12 to V15 are provided in the via layer VL1. The wirings 211 to 214 are provided in the metal wiring layer ML1. The via V11 has one end coupled to the wiring 231, and another end coupled to the wiring 221. The via V12 has one end coupled to the wiring 221, and another end coupled to the wiring 211. The via V13 has one end coupled to the wiring 221, and another end coupled to the wiring 212. The via V14 has one end coupled to the wiring 221, and another end coupled to the wiring 213. The via V15 has one end coupled to the wiring 221, and another end coupled to the wiring 214. The via V2 is disposed near the one end of the wiring 121 in the direction of extension thereof. The via V3 is disposed near the other end of the wiring 121 in the direction of extension thereof. The via V1 is provided at a position between the position of the via V2 and the position of the via V3. As viewed from above in the stacking direction, as illustrated in FIG. 17, the via V11 is provided at a position between a position of the via V12 and a position of the via V14, and between a position of the via V13 and a position of the via V15. In this example, the vias V12 to V15 are provided at mutually symmetrical positions as viewed from the via V11.

### [Modification Example 4]

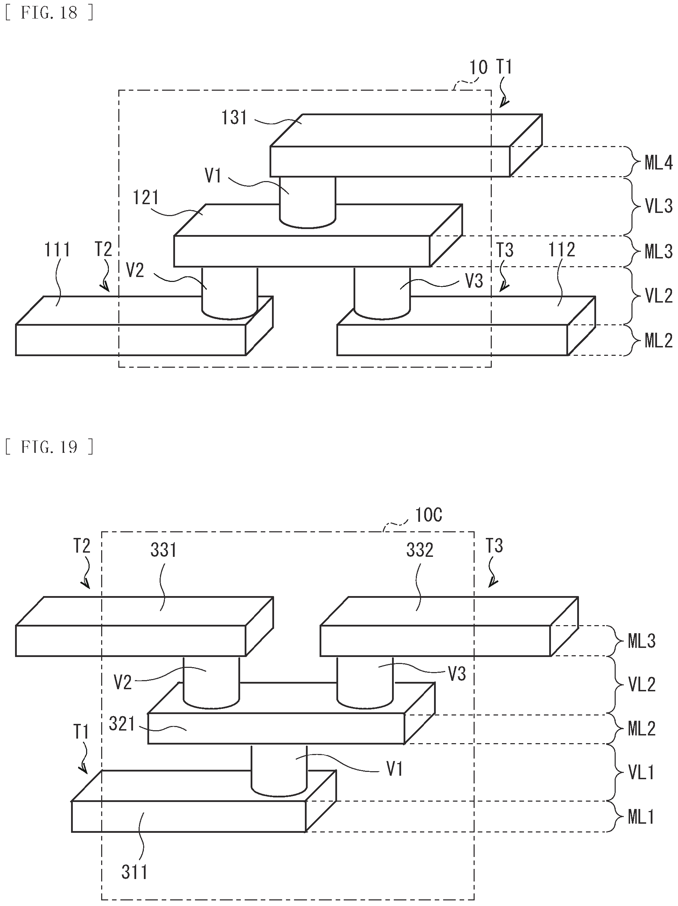

In the foregoing embodiment, the storage circuit 10 is provided in the metal wiring layer ML1, the via layer VL1, the metal wiring layer ML2, the via layer VL2, and the metal wiring layer ML3; however, this is non-limiting. Alternatively, for example, as illustrated in FIG. 18, the storage circuit 10 may be provided in the metal wiring layer ML2, the via layer VL2, the metal wiring layer ML3, a via layer VL3, and a metal wiring layer ML4. The metal wiring layer ML2 is the second one from the lowermost metal wiring layer, the metal wiring layer ML3 is the third one from the lowermost metal wiring layer, and the metal wiring layer ML4 is a fourth one from the lowermost metal wiring layer.

### [Modification Example 5]

In the foregoing embodiment, the via V1 is provided in the via layer VL2 and the vias V2 and V3 are provided in the via layer VL1; however, this is non-limiting. Alternatively, for example, as in a storage circuit 10C illustrated in FIG. 19, the via V1 may be provided in the via layer VL1 and the vias V2 and V3 may be provided in the via layer VL2. The storage circuit 10C includes wirings 311, 321, 331, and 332. The wiring 311 corresponds to the terminal T1, and is provided in the metal wiring layer ML1. The wiring 321 corresponds to the node NN, and is provided in the metal wiring layer ML2. The wirings 331 and 332 correspond to the terminals T2 and T3, respectively, and are provided in the metal wiring layer ML3. The via V1 has the one end coupled to the wiring 321, and the other end coupled to the wiring 311. The via V2 has the one end coupled to the wiring 331, and the other end coupled to the wiring 321. The via V3 has the one end coupled to the wiring 332, and the other end coupled to the wiring 321.

### [Modification Example 6]

In the foregoing embodiment, as illustrated in FIGs. 1 and 2, the via V2 is coupled to the switch 12 through the wiring 111, and the via V3 is coupled to the switch 13 through the wiring 112. As described below, a coupling part between the via V2 and the switch 12 and a coupling part between the via V3 and the switch 13 are desirably configured to allow for easy occurrence of electromigration in each of the vias V2 and V3.

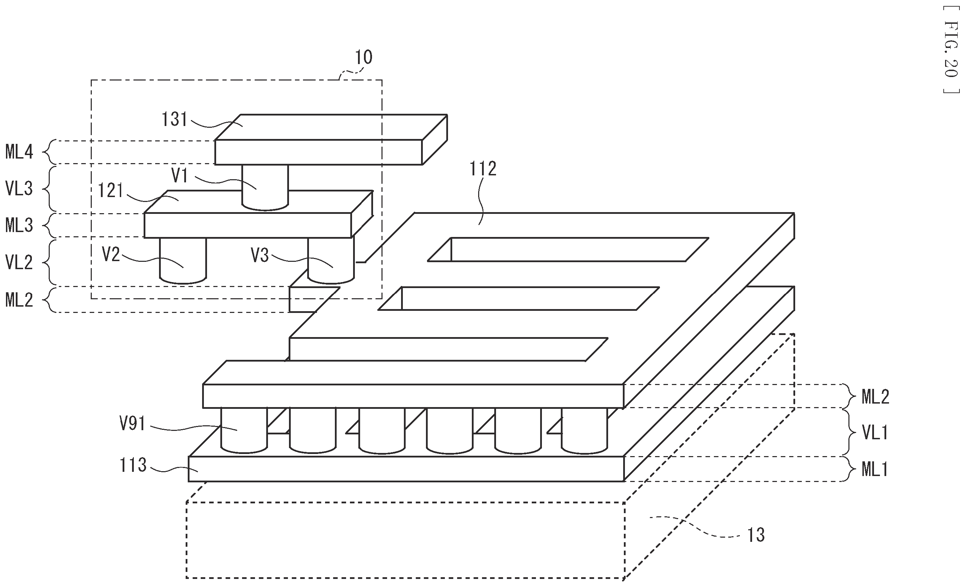

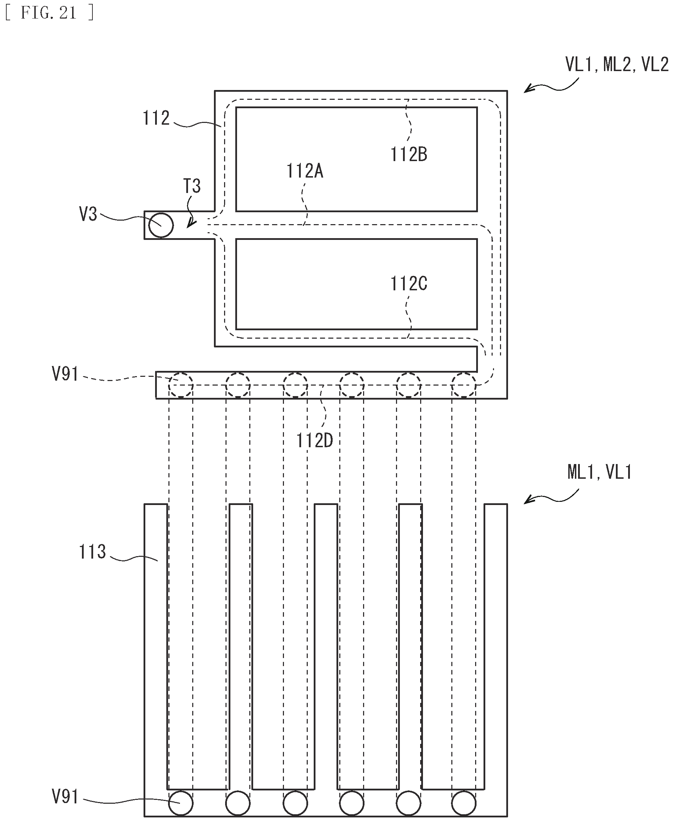

FIG. 20 illustrates an example of the coupling part between the via V3 and the switch 13 in the semiconductor storage device 1 according to the present modification example. FIG. 21 illustrates a configuration example of the metal wiring layers ML1 and ML2 and the via layers VL1 and VL2 in this coupling part. It is to be noted that although the coupling part between the via V3 and the switch 13 is illustrated in in FIGs. 20 and 21, a similar illustration applies to the coupling part between the via V2 and the switch 12. It is to be noted that in FIGs. 20 and FIG. 21, for convenience of illustration, details such as line widths of the wirings, sizes of the vias, positions of the vias, etc. are depicted somewhat differently.

As illustrated in FIG. 20, in this example, the storage circuit 10 is provided in the metal wiring layer ML2, the via layer VL2, the metal wiring layer ML3, the via layer VL3, and the metal wiring layer ML4. The via V3 is coupled to a transistor of the switch 13 provided in a semiconductor substrate below the wiring 113, through the wiring 112 in the metal wiring layer ML2, a plurality of vias V91 in the via layer VL1, and the wiring 113 in the metal wiring layer ML1.

As illustrated in FIG. 21, the wiring 112 includes three wiring parts 112A to 112C branched from the terminal T3 to which the via V3 is coupled, and a wiring part 112D in which the three wiring parts 112A to 112C merge with each other. In FIG. 21, paths of these three wiring parts 112A and 112C are illustrated in dashed lines. It is to be noted that although the wiring 112 includes the three wiring parts 112A to 112C branched from the terminal T3 in this example, this is non-limiting, and the wiring 112 may include two wiring parts branched from the terminal T3, or may include four or more wiring parts branched from the terminal T3. The wiring part 112D is coupled to the wiring 113 in the metal wiring layer ML1 through the plurality of vias V91. The wiring 113 has a comb-like shape. Specifically, the wiring 113 includes a wiring part extending in a horizontal direction in FIG. 21, and a plurality of (in this example, five) wiring parts extending from that wiring part in a vertical direction. The plurality of vias V91 is coupled to the wiring part, of the wiring 113, that extends in the horizontal direction. The plurality of wiring parts, of the wiring 113, that extends in the vertical direction is coupled to diffusion regions of the transistor provided in the semiconductor substrate, through a plurality of unillustrated contacts. More specifically, because transistors are often so laid out that mutually adjacent ones of a plurality of transistors coupled in parallel to each other share a diffusion region, the wiring 113 in the metal wiring layer ML1 coupled to the diffusion regions of the transistor has a comb-like shape as illustrated in FIG. 21.

As described above, in the semiconductor storage device 1, the wiring 112 includes the three wiring parts 112A to 112C branched from the terminal T3 to which the via V3 is coupled. This allows a current density to greatly vary in the vicinity of the via V3 when the write current flows. More specifically, the current density is high in the via V3, whereas in the wiring 112, the current density is low because of branching into the three wiring parts 112A to 112C. A gradient of the current density is therefore large in the vicinity of the via V3. Accordingly, in the vicinity of the via V3, a temperature gradient is large when the write current flows. As a result, in the via V3, easy occurrence of electromigration is achievable through the write current.

Further, the semiconductor storage device 1 is provided with the wiring 112 in the metal wiring layer ML2 and the wiring 113 in the metal wiring layer ML1. Accordingly, it is possible to make a wiring pattern of the wiring 112 into a pattern that allows electromigration to easily occur in the via V3. In addition, it is possible to make a wiring pattern of the wiring 113 into a pattern that corresponds to the transistor of the switch 13. This makes it possible for the semiconductor storage device 1 to achieve a reduction in area and to increase flexibility of layout design.

More specifically, for example, in a case where both the wiring 112 and the wiring 113 are formed using the metal wiring layer ML1, it is necessary that the pattern of the wiring 112 and the pattern of the wiring 113 be formed in different regions, which results in an increase in area. In contrast, the semiconductor storage device 1 is provided with the wiring 112 in the metal wiring layer ML2 and the wiring 113 in the metal wiring layer ML1. Accordingly, as illustrated in FIG. 20, it is possible for the pattern of the wiring 112 and the pattern of the wiring 113 to be formed in the same region. This makes it possible for the semiconductor storage device 1 to achieve a reduction in area and to increase flexibility of layout design.

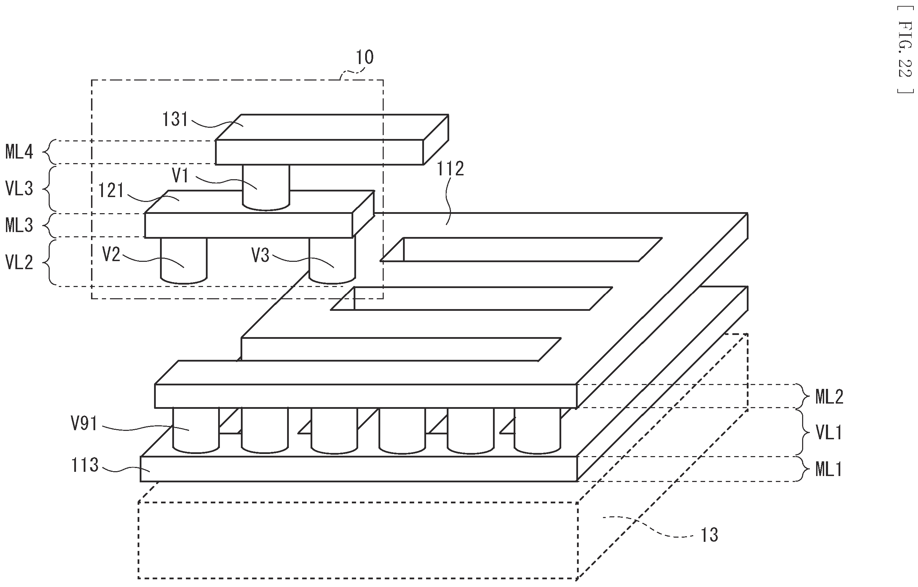

It is to be noted that in the example illustrated in FIGs. 20 and 21, the via V3 is provided at a position in the wiring 112 slightly away from a position at which the wiring 112 branches into the three wiring parts 112A to 112C; however, this is non-limiting. Alternatively, for example, as illustrated in FIG. 22, the via V3 may be provided at a position near the position at which the wiring 112 branches into the three wiring parts 112A to 112C.

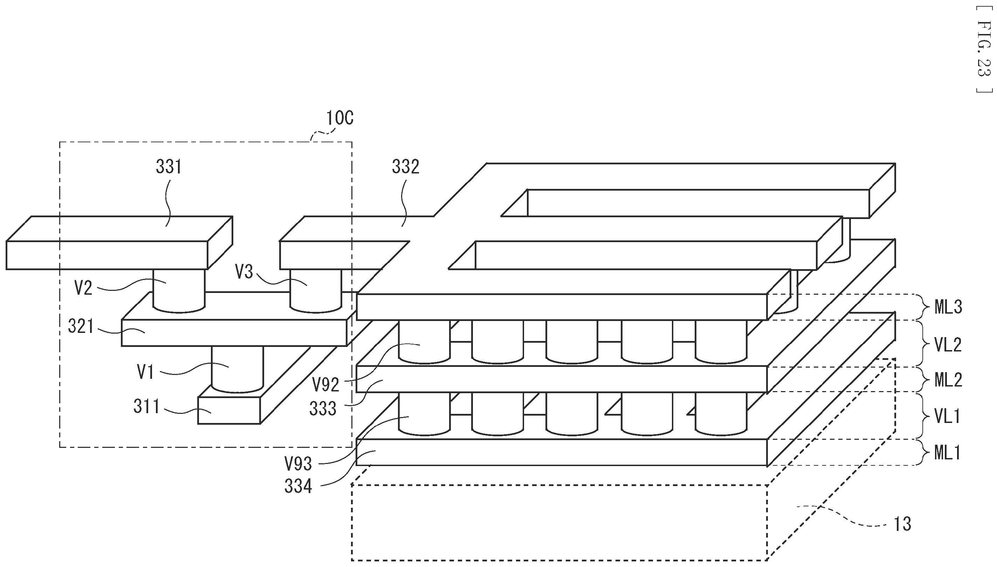

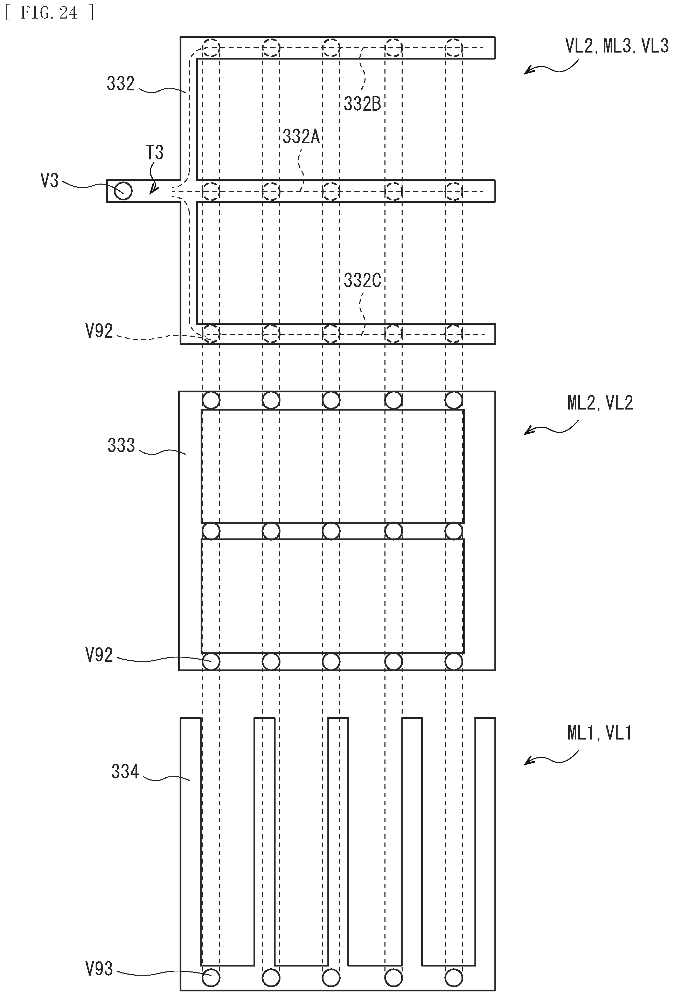

FIG. 23 illustrates an example of the coupling part between the via V3 and the switch 13 in another semiconductor storage device 1 according to the present modification example. FIG. 24 illustrates a configuration example of the metal wiring layers ML1, ML2, and ML3 and the via layers VL1 and VL2 in this coupling part. It is to be noted that although the coupling part between the via V3 and the switch 13 is illustrated in FIGs. 23 and 24, a similar illustration applies to the coupling part between the via V2 and the switch 12.

As illustrated in FIG. 23, in this example, the storage circuit 10C is provided in the metal wiring layer ML1, the via layer VL1, the metal wiring layer ML2, the via layer VL2, and the metal wiring layer ML3. The via V3 is coupled to the transistor of the switch 13 provided in a semiconductor substrate below a wiring 334, through the wiring 332 in the metal wiring layer ML3, a plurality of vias V92 in the via layer VL2, a wiring 333 in the metal wiring layer ML2, a plurality of vias V93 in the via layer VL1, and the wiring 334 in the metal wiring layer ML1.

As illustrated in FIG. 24, the wiring 332 includes three wiring parts 332A to 332C branched from the terminal T3 to which the via V3 is coupled. It is to be noted that although the wiring 332 includes the three wiring parts 332A to 332C branched from the terminal T3 in this example, this is non-limiting, and the wiring 332 may include two wiring parts branched from the terminal T3, or may include four or more wiring parts branched from the terminal T3. The three wiring parts 332A to 332C are each coupled to the wiring 333 in the metal wiring layer ML2 through the plurality of vias V92. The wiring 333 includes three wiring parts that extend in the horizontal direction and are provided at positions corresponding to the wiring parts 332A to 332C, and two wiring parts that extend in the vertical direction and couple the three wiring parts. In addition, the wiring part, of the wiring 333, that corresponds to the wiring part 332C is coupled to the wiring 334 in the metal wiring layer ML1 through the plurality of vias V93. The wiring 334 has a comb-like shape.

As described above, in the semiconductor storage device 1, the wiring 332 includes the three wiring parts 332A to 332C branched from the terminal T3 to which the via V3 is coupled. This allows the current density to greatly vary in the vicinity of the via V3 when the write current flows, and accordingly, in the vicinity of the via V3, the temperature gradient is large when the write current flows. As a result, in the via V3, easy occurrence of electromigration is achievable through the write current.

Further, the semiconductor storage device 1 is provided with the wiring 332 in the metal wiring layer ML3 and the wiring 334 in the metal wiring layer ML1. Accordingly, it is possible to make a wiring pattern of the wiring 332 into a pattern that allows electromigration to easily occur in the via V3. In addition, it is possible to make a wiring pattern of the wiring 334 into a pattern that corresponds to the transistor of the switch 13. This makes it possible for the semiconductor storage device 1 to achieve a reduction in area and to increase flexibility of the wiring pattern.

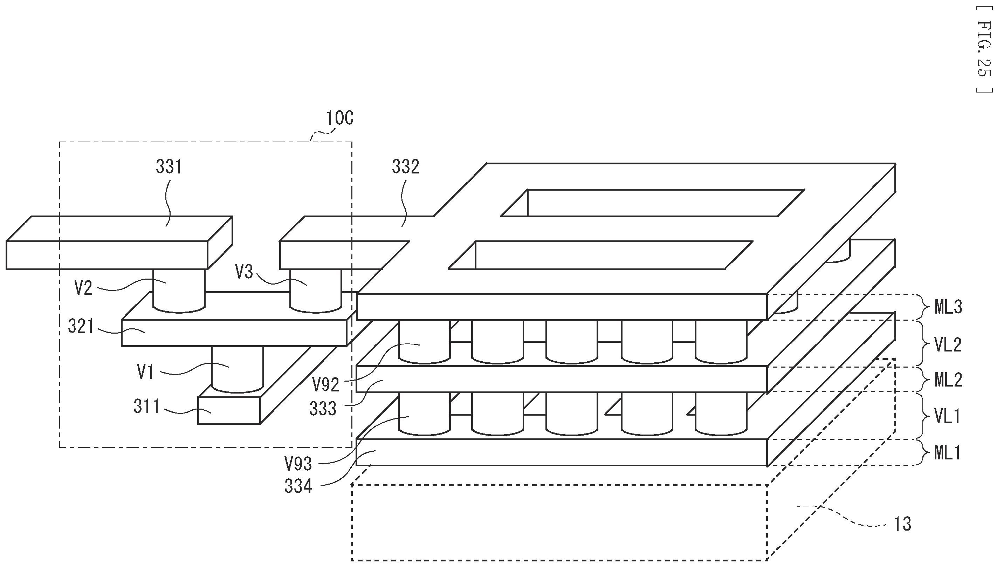

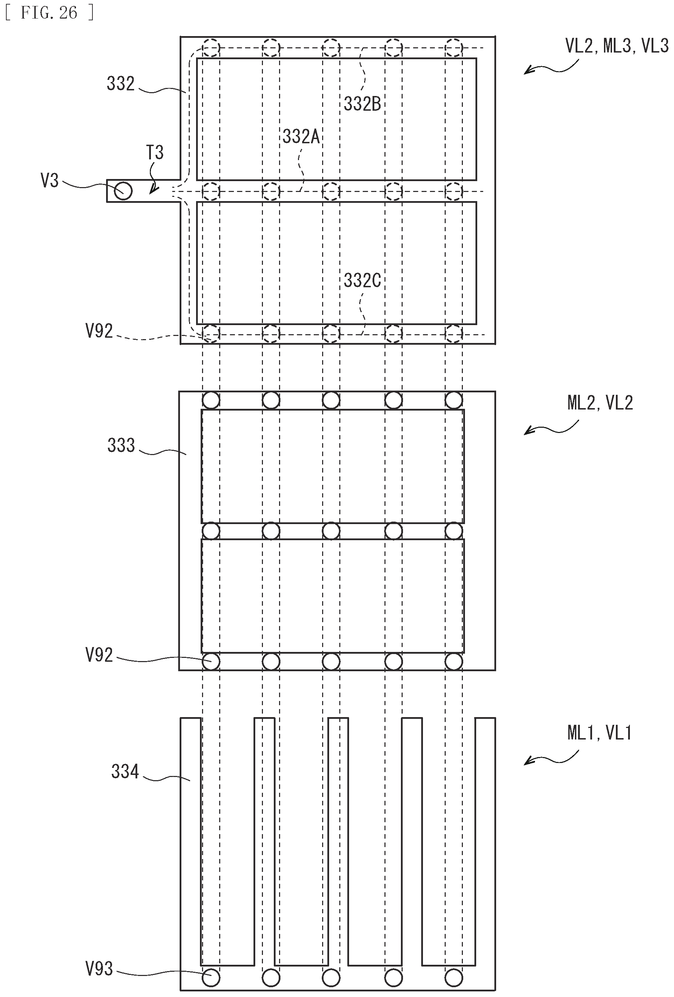

It is to be noted that in the example illustrated in FIGs. 23 and 24, the wiring 332 includes the three wiring parts 332A to 332C branched from the terminal T3 to which the via V3 is coupled; however, this is non-limiting. In addition, as illustrated in FIGs. 25 and 26, these three wiring parts 332A to 332C may be coupled to each other on a side (a right side in FIGs. 25 and 26) opposite to a branch part.

### [Other Modification Example]

Further, two or more of these modification examples may be combined.

Although the present technology has been described above with reference to the embodiment and the modification examples, the present technology is not limited to the embodiment and the like, and may be modified in a variety of ways.

Further, for example, although the single storage circuit 10 is provided in the foregoing embodiment and the like, this is non-limiting. Alternatively, for example, a plurality of storage circuits 10 may be provided. This allows for storing of more data.

It is to be noted that the effects described herein are merely illustrative and non-limiting, and other effects may be included.

It is to be noted that the present technology may have the following configurations. The present technology having the following configurations makes it possible to reduce power consumption while shortening the writing time.

(1) A semiconductor storage device including:
   a first via provided in a path coupling a first coupling terminal and a coupling node to each other, the first via being configured to irreversibly come into a high resistance state by passage of current therethrough;
   a second via provided in a path coupling the coupling node and a second coupling terminal to each other, the second via being configured to irreversibly come into a high resistance state by passage of current therethrough;
   a third via provided in a path coupling the coupling node and a third coupling terminal to each other, the third via being configured to irreversibly come into a high resistance state by passage of current therethrough; and
   a write circuit coupled to the first coupling terminal, the second coupling terminal, and the third coupling terminal, the write circuit being configured to allow a write current to flow bidirectionally between the first coupling terminal and the second coupling terminal, and configured to allow the write current to flow bidirectionally between the first coupling terminal and the third coupling terminal.
(2) The semiconductor storage device according to (1), in which
   the first via is configured to come into the high resistance state in a case where the write current flows in one of a first direction from the first coupling terminal toward the second coupling terminal and a second direction from the second coupling terminal toward the first coupling terminal, and
   the second via is configured to come into the high resistance state in a case where the write current flows in another one of the first direction and the second direction.
(3) The semiconductor storage device according to (1), further including
   a first wiring provided in a path coupling the second via and the write circuit to each other, the first wiring including a plurality of first wiring parts branched from the second via.
(4) The semiconductor storage device according to (3), further including
   a second wiring provided in the path coupling the second via and the write circuit to each other, the second wiring being provided in a wiring layer and coupled to a transistor, the wiring layer being a lowermost one of a plurality of wiring layers in the semiconductor storage device, in which
   the first wiring is provided in a wiring layer, of the plurality of wiring layers, that is upper relative to the wiring layer in which the second wiring is provided.
(5) The semiconductor storage device according to (4), further including
   a plurality of vias, in which
   the first wiring includes a second wiring part in which the first wiring parts merge with each other, and
   the plurality of vias couples the second wiring part of the first wiring and the second wiring to each other.
(6) The semiconductor storage device according to (4), further including
   a plurality of vias, in which
   the plurality of vias couples the first wiring parts and the second wiring to each other.
(7) The semiconductor storage device according to (1), in which
   the write circuit is:
   configured to bring the first via into the high resistance state by applying a first voltage to the first coupling terminal and applying a second voltage to the second coupling terminal;
   configured to bring the second via into the high resistance state by applying the second voltage to the first coupling terminal and applying the first voltage to the second coupling terminal; and
   configured to bring the third via into the high resistance state by applying the second voltage to the first coupling terminal and applying the first voltage to the third coupling terminal.
(8) The semiconductor storage device according to (7), in which the second voltage is higher than the first voltage.
(9) The semiconductor storage device according to (7), in which the first voltage is higher than the second voltage.
(10) The semiconductor storage device according to (1), in which
   the second via and the third via are provided in a first via layer, and
   the first via is provided in a second via layer.
(11) The semiconductor storage device according to (10), in which
   the coupling node is associated with a wiring layer, and
   the first via layer, the wiring layer, and the second via layer are stacked in this order.
(12) The semiconductor storage device according to (10) or (11), in which, in a plane intersecting a direction in which the first via layer and the second via layer are stacked, a position of the first via is between a position of the second via and a position of the third via.
(13) The semiconductor storage device according to (1), further including
   a read circuit configured to read a first bit value, based on a resistance value between the first coupling terminal and the second coupling terminal, and configured to read and detect a second bit value, based on a resistance value between the first coupling terminal and the third coupling terminal.

This application claims priority based on Japanese Patent Application No. 2023-148560 filed on September 13, 2023 with Japan Patent Office and International Application No. PCT/JP2024/026625 filed on July 25, 2024, the entire contents of each of which are incorporated in this application by reference.

It should be understood by those skilled in the art that various modifications, combinations, sub-combinations and alterations may occur depending on design requirements and other factors insofar as they are within the scope of the appended claims or the equivalents thereof.

## Claims

1. A semiconductor storage device comprising:
a first via provided in a path coupling a first coupling terminal and a coupling node to each other, the first via being configured to irreversibly come into a high resistance state by passage of current therethrough;
a second via provided in a path coupling the coupling node and a second coupling terminal to each other, the second via being configured to irreversibly come into a high resistance state by passage of current therethrough;
a third via provided in a path coupling the coupling node and a third coupling terminal to each other, the third via being configured to irreversibly come into a high resistance state by passage of current therethrough; and
a write circuit coupled to the first coupling terminal, the second coupling terminal, and the third coupling terminal, the write circuit being configured to allow a write current to flow bidirectionally between the first coupling terminal and the second coupling terminal, and configured to allow the write current to flow bidirectionally between the first coupling terminal and the third coupling terminal.

2. The semiconductor storage device according to claim 1, wherein
the first via is configured to come into the high resistance state in a case where the write current flows in one of a first direction from the first coupling terminal toward the second coupling terminal and a second direction from the second coupling terminal toward the first coupling terminal, and
the second via is configured to come into the high resistance state in a case where the write current flows in another one of the first direction and the second direction.

3. The semiconductor storage device according to claim 1, further comprising
a first wiring provided in a path coupling the second via and the write circuit to each other, the first wiring including a plurality of first wiring parts branched from the second via.

4. The semiconductor storage device according to claim 3, further comprising
a second wiring provided in the path coupling the second via and the write circuit to each other, the second wiring being provided in a wiring layer and coupled to a transistor, the wiring layer being a lowermost one of a plurality of wiring layers in the semiconductor storage device, wherein
the first wiring is provided in a wiring layer, of the plurality of wiring layers, that is upper relative to the wiring layer in which the second wiring is provided.

5. The semiconductor storage device according to claim 4, further comprising
a plurality of vias, wherein
the first wiring includes a second wiring part in which the first wiring parts merge with each other, and
the plurality of vias couples the second wiring part of the first wiring and the second wiring to each other.

6. The semiconductor storage device according to claim 4, further comprising
a plurality of vias, wherein
the plurality of vias couples the first wiring parts and the second wiring to each other.

7. The semiconductor storage device according to claim 1, wherein
the write circuit is:
configured to bring the first via into the high resistance state by applying a first voltage to the first coupling terminal and applying a second voltage to the second coupling terminal;
configured to bring the second via into the high resistance state by applying the second voltage to the first coupling terminal and applying the first voltage to the second coupling terminal; and
configured to bring the third via into the high resistance state by applying the second voltage to the first coupling terminal and applying the first voltage to the third coupling terminal.

8. The semiconductor storage device according to claim 7, wherein the second voltage is higher than the first voltage.

9. The semiconductor storage device according to claim 7, wherein the first voltage is higher than the second voltage.

10. The semiconductor storage device according to claim 1, wherein
the second via and the third via are provided in a first via layer, and
the first via is provided in a second via layer.

11. The semiconductor storage device according to claim 10, wherein
the coupling node is associated with a wiring layer, and
the first via layer, the wiring layer, and the second via layer are stacked in this order.

12. The semiconductor storage device according to claim 10, wherein, in a plane intersecting a direction in which the first via layer and the second via layer are stacked, a position of the first via is between a position of the second via and a position of the third via.

13. The semiconductor storage device according to claim 1, further comprising
a read circuit configured to read a first bit value, based on a resistance value between the first coupling terminal and the second coupling terminal, and configured to read and detect a second bit value, based on a resistance value between the first coupling terminal and the third coupling terminal.
